# EUROPEAN PATENT APPLICATION

(11) **EP 4 604 699 A1**
(43) Date of publication of application: **20.08.2025**
(21) Application number: 25153999.5
(22) Date of filing: 27.01.2025
(51) Int. Cl.: H10K 59/121, H10K 59/128, H10K 59/80

(54) **DISPLAY DEVICE**

(30) Priority: 16.02.2024 KR 20240022662
(71) Applicant: Samsung Display Co., Ltd., Yongin-si, Gyeonggi-do 17113 (KR)
(72) Inventor: CHUNG, Jinkoo, Giheung-Gu, Yongin-si, Gyeonggi-Do (KR); KIM, Seong-Min, Giheung-Gu, Yongin-si, Gyeonggi-Do (KR); JANG, Kyungsoo, Giheung-Gu, Yongin-si, Gyeonggi-Do (KR); CHOI, Nakcho, Giheung-gu, Yongin-si, Gyeonggi-do (KR); CHOI, Yoonsun, Giheung-gu, Yongin-si, Gyeonggi-do (KR); CHOI, Jungmin, Giheung-gu, Yongin-si, Gyeonggi-do (KR)
(74) Representative: Dr. Weitzel & Partner

(57) **Abstract**

A display device includes a display panel having a first display surface and a second display surface defined continuously in a first direction on a plane, and a light control layer disposed on the display panel, wherein the light control layer includes a first partition wall extending onto the first display surface in the first direction, and a second partition wall extending onto the second display surface in a second direction intersecting the first direction on a plane.

## Description

### BACKGROUND

### 1. Field

The invention relates to a display device.

### 2. Description of Related Art

Display devices such as televisions, monitors, smart phones, and tablet personal computers (PCs) that provide images to users include display panels that display images. Furthermore, the display devices may be arranged inside vehicles to provide images to users sitting in a driver seat or in a passenger seat.

### SUMMARY

The present invention is defined by the features of the independent claims. The dependent claims describe preferred embodiments.

Embodiments of the invention provide a display device in which an image provided from a display surface may be prevented from being focused on a front window. Furthermore, embodiments of the invention also provide a display device in which an image which is provided from a portion of a display surface disposed adjacent to a passenger seat may be prevented from being visually recognized by a user sitting in a driver seat.

According to an embodiment, a display device includes a display panel having a first display surface and a second display surface defined continuously in a first direction on a plane, and a light control layer disposed on the display panel, wherein the light control layer includes a first partition wall extending onto the first display surface in the first direction, and a second partition wall extending onto the second display surface in a second direction intersecting the first direction.

The display device may include a plurality of main light emitting areas defined on the first display surface and the second display surface; and a plurality of sub-light emitting areas defined on the second display surface, wherein the plurality of sub-light emitting areas are arranged to be adjacent to the main light emitting areas, and wherein the second partition wall overlaps the plurality of sub-light emitting areas on the plane.

An arrangement shape of the main light emitting areas defined on the first display surface and an arrangement shape of the main light emitting areas defined on the second display surface may be different from each other.

The first partition wall may be disposed on the second display surface, and the first partition wall may intersect the second partition wall on the second display surface.

The sub-light emitting areas may be defined on the first display surface to be disposed adjacent to the main light emitting areas, and the second partition wall may be disposed on the first display surface and overlaps the sub-light emitting areas.

An arrangement shape of the main light emitting areas and an arrangement shape of the sub-light emitting areas defined on the first display surface may be the same as an arrangement shape of the main light emitting areas and an arrangement shape of the sub-light emitting areas defined on the second display surface.

The main light emitting areas and the sub-light emitting areas may be arranged in the first direction, that is, may be disposed one behind another in the first direction.

The main light emitting areas and the sub-light emitting areas may be arranged in the second direction, that is, may be disposed one behind another in the second direction.

According to an embodiment, the main light emitting areas include a first light emitting area, a second light emitting area spaced apart from the first light emitting area in the second direction, and a third light emitting area spaced apart from the first light emitting area and the second light emitting area in the first direction, the sub-light emitting areas include a first sub-light emitting area defined on one side of the first light emitting area, a second sub-light emitting area defined on one side of the second light emitting area, and a third sub-light emitting area defined between another side of the first light emitting area and a side of the third light emitting area facing the other side of the first light emitting area, and disposed between another side of the second light emitting area and the one side of the third light emitting area.

The display panel may include a circuit element layer, a display element layer disposed on the circuit element layer and including a plurality of light emitting elements, and a thin film encapsulation layer disposed on the display element layer, wherein the light control layer is disposed on the thin film encapsulation layer.

The display panel may further include an input sensing layer disposed between the thin film encapsulation layer and the light control layer.

The display panel may further include a reflection preventing layer disposed between the input sensing layer and the light control layer.

The light control layer may include a plurality of first partition walls arranged in the second direction, that is, may be disposed one behind another in the second direction, and a first length which is defined as a distance between adjacent first partition walls among the plurality of first partition walls in the second direction may be smaller than a second length which is defined as a thickness of a first partition wall among the plurality of first partition walls. The thickness may be defined in a third direction which is perpendicular to the plane defined by the first direction and the second direction, that is, a thickness direction of the display panel. The thickness thus may be termed as a height of the partition wall.

The light control layer may include a plurality of second partition walls arranged in the first direction, that is, may be disposed one behind another in the first direction, and a thickness of a second partition wall among the plurality of second partition walls may be greater than a distance between adjacent second partition walls among the plurality of second partition walls in the first direction.

The first partition wall may include a plurality of first sub-partition walls that are sequentially laminated in a third direction which intersects a plane defined by the first direction and the second direction, and the second partition wall may include a plurality of second sub-partition walls that are sequentially laminated in the third direction on the plane.

According to an embodiment, a display device includes a display panel having a circuit element layer and a display element layer disposed on the circuit element layer, and a light control layer disposed on the display panel and including a plurality of partition walls, wherein a first length, which is defined as a distance between the partition walls, is smaller than a second length, which is defined as a height of the partition walls.

The display panel may include a first display surface and a second display surface continuously defined in a first direction, and an arrangement shape of the plurality of partition walls arranged on the first display surface and an arrangement shape of the plurality of partition walls arranged on the second display surface may be the same.

The plurality of partition walls may include a plurality of first partition walls arranged on the first display surface and the second display surface and extending in the first direction on a plane, and a plurality second partition walls arranged on the first display surface and the second display surface and extending in a second direction intersecting the first direction.

The display panel may include a first display surface and a second display surface continuously defined in a first direction on a plane, and an arrangement shape of the plurality of partition walls arranged on the first display surface and an arrangement shape of the plurality of partition walls arranged on the second display surface may be different from each other.

The plurality of partition walls may include a plurality of first partition walls arranged on the first display surface and extending in the first direction on a plane, and a plurality of second partition walls arranged on the second display surface and extending in a second direction interesting the first direction.

### BRIEF DESCRIPTION OF THE FIGURES

The above and other objects and features of the invention will become apparent by describing in detail embodiments thereof with reference to the accompanying drawings.
FIG. 1 is a graphical view of an interior of a vehicle, according to an embodiment.
FIG. 2 is a view of a display device illustrated in FIG. 1, according to an embodiment.
FIG. 3 is a schematic cross-sectional view of the display device illustrated in FIG. 2, according to an embodiment.
FIG. 4 is a cross-sectional view of a display panel illustrated in FIG. 3, according to an embodiment.
FIG. 5 is a plan view of the display panel illustrated in FIG. 4, according to an embodiment.
FIG. 6A is an enlarged plan view of a first area AA1 illustrated in FIG. 5, according to an embodiment.
FIG. 6B is an enlarged plan view of a first area AA1 illustrated in FIG. 5, according to an embodiment.
FIG. 7A is an enlarged plan view of a second display surface, according to an embodiment.
FIG. 7B is an enlarged plan view of a second display surface, according to an embodiment.
FIG. 8A is an enlarged plan view of the second display surface, according to an embodiment.
FIG. 8B is an enlarged plan view of the second display surface, according to an embodiment.
FIG. 8C is an enlarged plan view of the second display surface, according to an embodiment.
FIG. 9A is a cross-sectional view of the display device, according to an embodiment.
FIG. 9B is a cross-sectional view of the display device, according to an embodiment.
FIG. 9C is a cross-sectional view of the display device, according to an embodiment.
FIG. 9D is a cross-sectional view of the display device, according to an embodiment.
FIG. 10A is a view for describing a first display surface and the second display surface, according to an embodiment.
FIG. 10B is a view for describing a first display surface and the second display surface, according to an embodiment.
FIG. 10C is a view for describing a first display surface and the second display surface, according to an embodiment.
FIG. 11 is a visual graphic for describing a movement direction of a light emitted from the display panel, according to an embodiment.

### DETAILED DESCRIPTION

Advantages and features of the invention and a method of achieving the advantages and the features will become apparent with reference to an embodiment described below in detail in conjunction with the accompanying drawings. However, the invention is not limited to the embodiments described below but will be implemented in various forms, and the present embodiments merely make the disclosure of the invention complete and are provided to completely inform the scope of the invention to those skilled in the art to which the present invention belongs. Throughout the specification, the same reference numerals refer to the same components.

When it is mentioned that a first element or layer is disposed "on" or "above" a second element or layer, this includes both a case in which the first element or layer is disposed directly on or above the second element or layer and a case in which a third element or layer is interposed therebetween. On other hand, when it is mentioned that the first element is disposed directly "on" or "above" the second element, this indicates that the third element or layer is not interposed therebetween. The term "and/or" includes each of mentioned items and all combinations of one or more of the mentioned items.

Spatially relative terms such as "below", "beneath", "lower", "above", and "upper" may be used to easily describe a correlation between a first element or component and a second element or component as illustrated in the drawings. The spatially relative terms should be understood as terms including different directions of elements during use or operation in addition to directions illustrated in the drawings. Throughout the specification, the same reference numerals refer to the same components.

Although first, second, and the like are used to describe various elements, various components, and/or various sections, it is apparent that these elements, these components and/or these sections are not limited by these terms. These terms are only used to distinguish one element, one component, or one section from another element, another component, or another section. Thus, it is apparent that a first element, a first component, or a first section mentioned below may be a second element, a second component, or a second section.

Embodiments described herein will be described with reference to a plan view and a cross-sectional view that are ideal schematic views of the invention. Thus, a shape of an illustrative drawing may be modified due to a manufacturing technology and/or a tolerance. Thus, the embodiments of the invention are not limited to specific illustrated shapes but also include changes of shapes generated according to a manufacturing process. Thus, the areas illustrated in the drawings have schematic properties, and the shapes of the areas illustrated in the drawings are intended to illustrate specific shapes of areas of elements and not to limit the scope of the invention.

Hereinafter, the invention will be described in more detail with reference to the accompanying drawings.

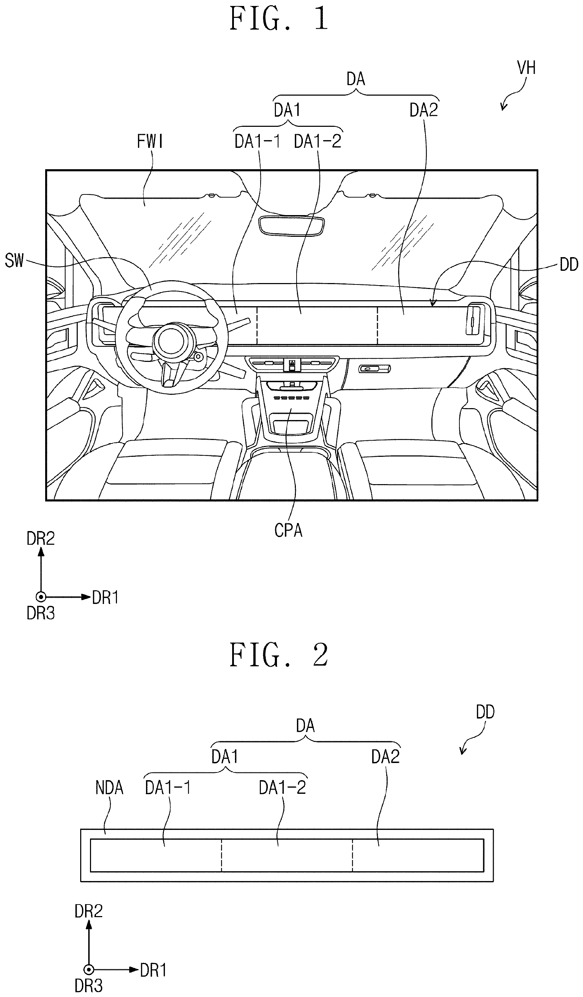

FIG. 1 is a schematic view illustrating an interior of a vehicle, according to an embodiment. FIG. 2 is a view of a display device illustrated in FIG. 1, according to an embodiment.

In an embodiment and referring to FIGS. 1 and 2, a vehicle VH may include a steering wheel SW, a center fascia CPA, a front window FWI, and a display device DD, where the steering wheel SW may be positioned in front of a driver's seat. A driver may control a movement direction of the vehicle VH through the steering wheel SW. The steering wheel SW may include a ring shape, but the invention is not limited thereto.

The center fascia CPA may be disposed between the driver's seat and a passenger seat and may include controllers in which a plurality of buttons for controlling an audio device, an air conditioning device, and a seat heater are arranged.

The front window FWI may be installed on a front side of the vehicle VH and may be disposed in front of the steering wheel SW. The front window FWI may be constructed of glass.

The display device DD may be disposed in front of the steering wheel SW to be disposed between the steering wheel SW and the front window FWI. The display device DD may have a rectangular shape having long sides extending in a first direction DR1 and short sides extending in a second direction DR2 intersecting the first direction DR1 on a plane. However, the invention is not limited thereto, and the display device DD may have various shapes such as a circle and a polygonal shape on a plane.

Hereinafter, a direction substantially perpendicular to a plane which is defined by the first direction DR1 and the second direction DR2 is defined as a third direction DR3. Further, in the specification the wording "when viewed on a plane" may be defined as a state viewed from the third direction DR3.

The display device DD may include a display area DA and a non-display area NDA. The display device DD may display an image through the display area DA, wherein the display area DA may be directed parallel to a plane which is defined by the first direction DR1 and the second direction DR2.

The non-display area NDA may be disposed adjacent to the display area DA. Illustratively, the non-display area NDA has a shape surrounding the display area DA, but the invention is not limited thereto, and the non-display area NDA may be disposed adjacent to one side of the display area DA or it may be omitted. The non-display area NDA may be an area that does not display an image.

The display area DA may include a first area DA1 and a second area DA2. The first area DA1 and the second area DA2 may be arranged in the first direction DR1. The second area DA2 may extend from the first area DA1 in the first direction DR1. The first area DA1 and the second area DA2 may be formed integrally.

The first area DA1 may include a (1-1)^{th} sub-area DA1-1 and a (1-2)^{th} sub-area DA1-2. The (1-1)^{th} sub-area DA1-1 may be positioned in front of the steering wheel SW and may be configured as a cluster. The (1-1)^{th} sub-area DA1-1 may display, to a user sitting in the driver's seat, images of a tachometer, a speedometer, a coolant temperature gauge, a fuel gauge, a turn indicator light, a high beam, an indicator light, a warning light, a seat belt warning light, an odometer, an odograph, an automatic shift selector lever light, a door open warning light, an engine oil warning light, a low fuel warning light, or the like.

The (1-2)^{th} sub-area DA1-2 may be disposed in front of the center fascia CPA and may display, to the user, images of a navigation system, an internal status of the vehicle VH, music being played, and the like.

The second area DA2 may be disposed in front of the passenger seat and may provide images to the user sitting in the passenger seat. The images provided in the second area DA2 may not be visually recognized to the user sitting in the driver's seat. A detailed description thereof will be made below.

The images provided in the first area DA1 and the second area DA2 may not move toward the front window FWI. In another embodiment, the images provided in the first area DA1 and the second area DA2 may travel toward the front window FWI in relatively low brightness. However, the invention is not limited thereto, and only the image provided in the first area DA1 may not travel toward the front window FWI. A detailed description thereof will be made below.

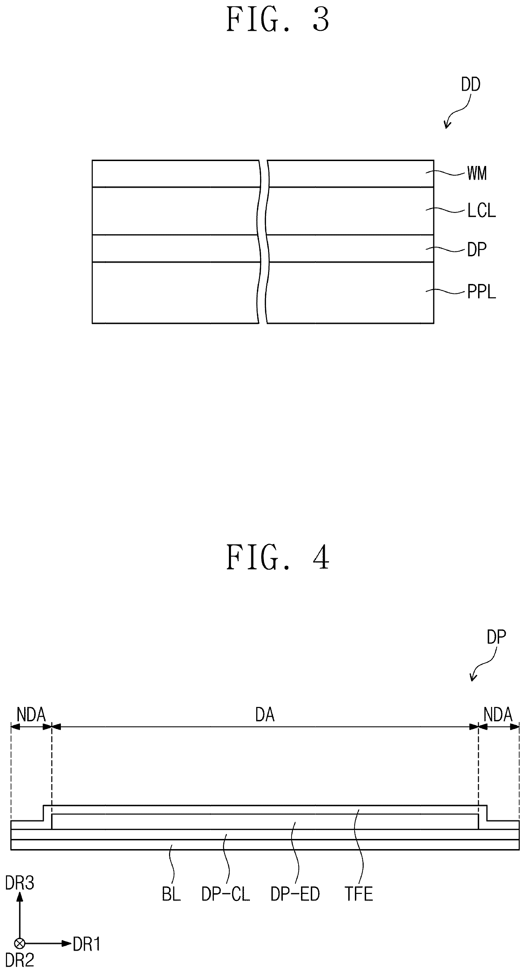

FIG. 3 is a schematic cross-sectional view of the display device illustrated in FIG. 2, according to an embodiment.

In an embodiment and referring to FIG. 3, the display device DD may include a display panel DP, a panel protecting layer PPL, a light control layer LCL, and a window WM. The display panel DP may be a light emitting display panel, and the invention is not particularly limited. For example, the display panel DP may be an organic light emitting display panel or an inorganic light emitting display panel. A light emitting layer of the organic light emitting display panel may include an organic light emitting material. A light emitting layer of the inorganic light emitting display panel may include a quantum dot and a quantum rod. Hereinafter, the display panel DP will be described as the organic light emitting display panel.

The panel protecting layer PPL may be disposed under the display panel DP and may protect a lower portion of the display panel DP. The panel protecting layer PPL may include a flexible plastic material. For example, in an embodiment, the panel protecting layer PPL may include polyethylene terephthalate (PET).

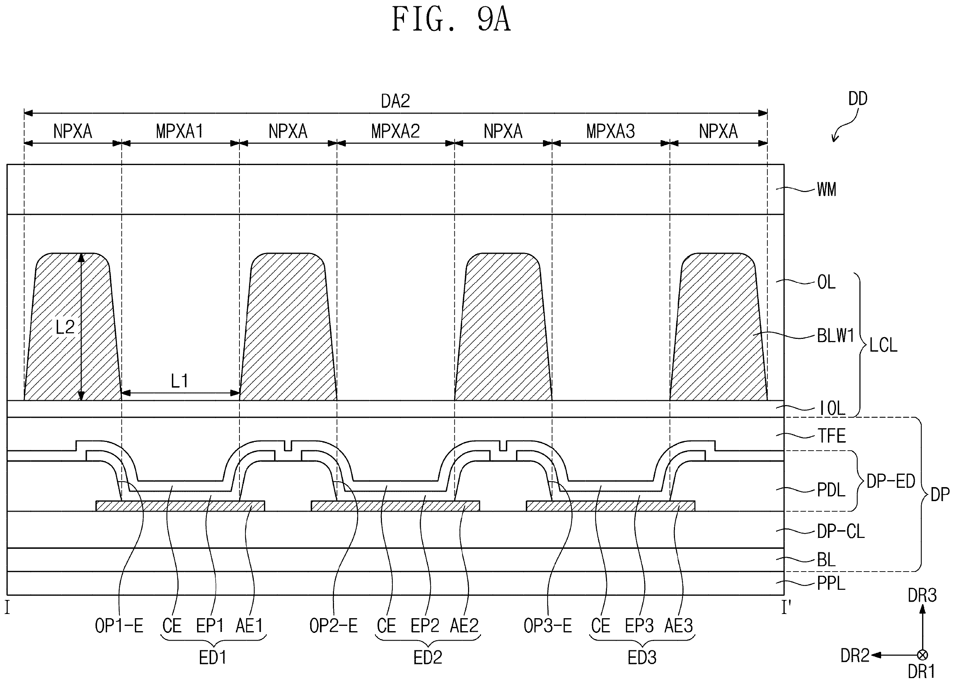

The light control layer LCL may be disposed on the display panel DP and may control a light emitted from the display panel DP such that the light travels in a specific direction. A detailed description of the light control layer LCL will be described in detail in FIGS. 9A to 9D.

The window WM may be disposed on the light control layer LCL and may be formed directly on the light control layer LCL or may be coupled to the light control layer LCL by an adhesive layer. The window WM may protect the display panel DP and the light control layer LCL from external scratches and impacts.

Although not illustrated, the display device DD may further include an input sensor, a reflection preventing layer, and the like.

FIG. 4 is a cross-sectional view of a display panel illustrated in FIG. 3, according to an embodiment.

Illustratively, FIG. 4 is a cross-sectional view of the display panel DP when viewed in the second direction DR2.

Since the display area DA and the non-display area NDA of FIG. 4 are the same as the display area DA and the non-display area NDA of FIG. 2, descriptions thereof will be omitted or simplified.

In an embodiment and referring to FIG. 4, the display panel DP may include a base layer BL, and a circuit element layer DP-CL, a display element layer DP-ED, and an encapsulation layer TFE arranged on the base layer BL. The base layer BL may include at least one plastic film. The base layer BL may include a plastic substrate, a glass substrate, a metal substrate, or an organic/inorganic composite material substrate.

The circuit element layer DP-CL may include at least one intermediate insulating layer and at least one circuit element layer. The intermediate insulating layer may include at least one intermediate inorganic layer and at least one intermediate organic layer. The circuit element may also include signal lines, a pixel driving circuit, and the like.

The display element layer DP-ED may include a plurality of organic light emitting diodes. The display element layer DP-ED may further include an organic layer such as a pixel defining film.

The encapsulation layer TFE may seal the display element layer DP-ED and may be disposed on the display element layer DP-ED. The encapsulation layer TFE may also overlap the display area DA and the non-display area NDA.

The encapsulation layer TFE may include a laminated structure of an inorganic layer, an organic layer, and an inorganic layer. The encapsulation layer TFE may protect the display element layer DP-ED from foreign substances such as moisture, oxygen, and dust particles. However, the invention is not limited thereto, and the encapsulation layer TFE may further include an additional insulating layer.

In an embodiment, an encapsulation substrate may be provided instead of the encapsulation layer TFE. In this embodiment, the encapsulation substrate may face the base layer BL, and the circuit element layer DP-CL and the display element layer DP-ED may be arranged to be disposed between the encapsulation substrate and the base layer BL.

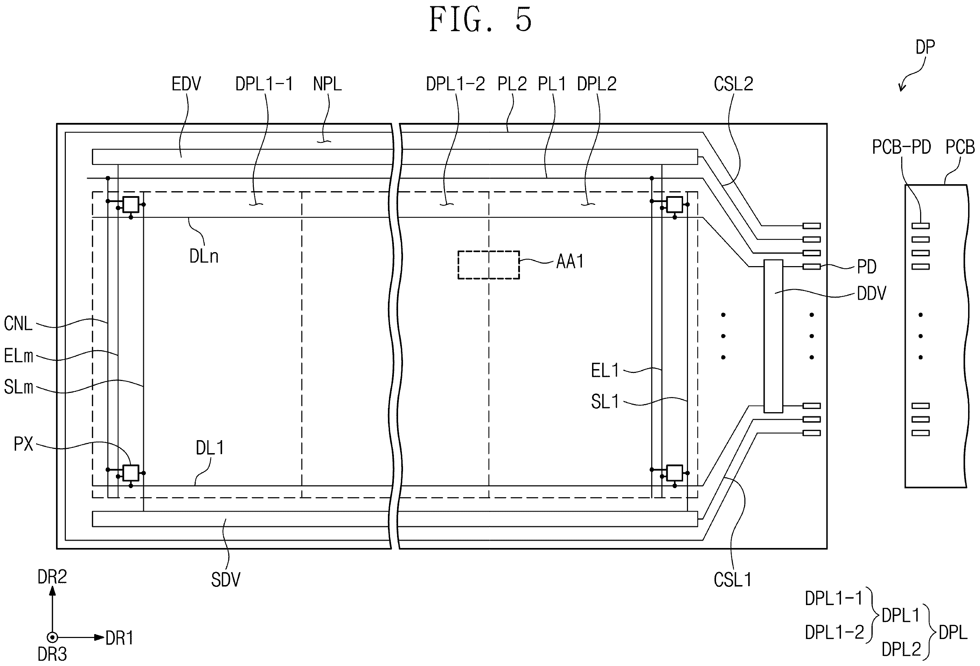

FIG. 5 is a plan view of the display panel illustrated in FIG. 4, according to an embodiment.

In an embodiment and referring to FIG. 5, the display panel DP may include a display surface DPL and a non-display surface NPL. The display surface DPL may be defined as a surface corresponding to the display area DA in FIG. 2. The non-display surface NPL may be defined as a surface that corresponds to the non-display area NDA in FIG. 2. On a plane, the non-display surface NPL may surround the display surface

### DPL.

In an embodiment, the display surface DPL may include a first display surface DPL1 and a second display surface DPL2. The first display surface DPL1 and the second display surface DPL2 may be arranged in the first direction DR1, where the first display surface DPL1 may correspond to the first area DA1 of FIG. 2, and the second display surface DPL2 may correspond to the second area DA2 of FIG. 2.

The first display surface DPL1 may include a first sub-display surface DPL1-1 and a second sub-display surface DPL1-2. The first sub-display surface DPL1-1 and the second sub-display surface DPL1-2 may be arranged in the first direction DR1. The first sub-display surface DPL1-1 may correspond to the (1-1)^{th} sub-area DA1-1 in FIG. 2, and the second sub-display surface DPL1-2 may correspond to the (1-2)^{th} sub-area DA1-2 of FIG. 2.

The display panel DP may include a plurality of pixels PX, a plurality of scan lines SL1 to SLm, a plurality of data lines DL1 to DLn, a plurality of light emitting lines EL1 to ELm, first and second control lines CSL1 and CSL2, a first power line PL1, a second power line PL2, a plurality of connection lines CNL, and a plurality of pads PD, where "m" and "n" are natural numbers. The pixels PX may be arranged on the display surface DPL and may be connected to the scan lines SL1 to SLm, the data lines DL1 to DLn, and the light emitting lines EL1 to ELm.

In an embodiment, a scan driving unit SDV and a light emitting driving unit EDV may be arranged on the non-display surface NPL. The scan driving unit SDV and the light emitting driving unit EDV may be spaced apart from each other in the second direction DR2. A data driving unit DDV may be disposed on the non-display surface NPL and may be disposed adjacent to one of both sides of the display panel DP, which are disposed opposite to each other in the first direction DR1. The data driving unit DDV may be manufactured in the form of an integrated circuit chip and may be mounted on the non-display surface NPL. The one of both sides of the display panel DP, which are disposed opposite to each other in the first direction DR1, may be defined as a side on which the pads PD are arranged.

In an embodiment, the scan lines SL1 to SLm may extend in the second direction DR2 and may be connected to the scan driving unit SDV. The data lines DL1 to DLn may extend in the first direction DR1 and may be connected to the data driving unit DDV. The light emitting lines EL1 to ELm may extend in the second direction DR2 and may be connected to the light emitting driving unit EDV.

In an embodiment, the first power line PL1 may extend in the first direction DR1 and may be disposed in the non-display surface NPL. The first power line PL1 may be disposed between the display surface DPL and the light emitting driving unit EDV, but the invention is not limited thereto, and the first power line PL1 may be disposed between the display surface DPL and the scan driving unit SDV. The first power line PL1 may extend toward the one of both sides of the display panel DP, which are disposed opposite to each other in the first direction DR1, and may receive a first voltage.

In an embodiment, the second power line PL2 may be disposed on the non-display surface NPL to be adjacent to the long sides of the display panel DP and the non-display surface NPL to be adjacent to the other one of both sides of the display panel DP, which are disposed opposite to each other in the first direction DR1. The second power line PL2 may be disposed outside the scan driving unit SDV and the light emitting driving unit EDV.

The second power line PL2 may extend toward the one of both sides of the display panel DP, which are disposed opposite to each other in the first direction DR1. Both ends of the second power line PL2 may extend in the first direction DR1 with the data driving unit DDV interposed therebetween.

The second power line PL2 may receive a second voltage having a lower level than that of the first voltage. For convenience of description, a connection relationship is not illustrated, but the second power line PL2 may extend to the display surface DPL and may be connected to the pixels PX, where the second voltage may be provided to the pixels PX through the second power line PL2.

In an embodiment, the connection lines CNL may extend in the second direction DR2 and may be arranged in the first direction DR1. The connection lines CNL may be connected to the first power line PL1 and the pixels PX. The first voltage may be applied to the pixels PX through the first power line PL1 and the connection lines CNL connected to each other.

In an embodiment, the first control line CSL1 may be connected to the scan driving unit SDV and may extend toward the one of both sides of the display panel DP, which are disposed opposite to each other in the first direction DR1. The second control line CSL2 may be connected to the light emitting driving unit EDV and may extend toward the one of both sides of the display panel DP, which are disposed opposite to each other in the first direction DR1. The data driving unit DDV may be disposed between the first control line CSL1 and the second control line CSL2.

On a plane, the pads PD may be arranged to be adjacent to the one of both sides of the display panel DP, which are disposed opposite to each other in the first direction DR1. The data driving unit DDV, the first power line PL1, the second power line PL2, the first control line CSL1, and the second control line CSL2 may be connected to the pads PD.

In an embodiment, the data lines DL1 to DLn may be connected to the correspondence pads PD through the data driving unit DDV. For example, the data lines DL1 to DLn may be connected to the data driving unit DDV, and the data driving unit DDV may be connected to the pads PD which respectively corresponds to the data lines DL1 to DLn.

In an embodiment, a printed circuit board PCB may be connected to the display panel DP. The printed circuit board PCB may be connected to the pads PD. Connection pads PCB-PD of the printed circuit board PCB may be connected to the pads PD.

In an embodiment, a timing controller (not illustrated) may be disposed on the printed circuit board PCB, where the timing controller may be connected to the pads PD through the printed circuit board PCB. The timing controller may control operations of the scan driving unit SDV, the data driving unit DDV, and the light emitting driving unit EDV. The timing controller may also generate a scan control signal, a data control signal, and a light emitting control signal in response to control signals received from an external unit.

In an embodiment, the scan control signal may be provided to the scan driving unit SDV through the first control line CSL1. The light emitting control signal may be provided to the light emitting driving unit EDV through the second control line CSL2. The data control signal may be provided to the data driving unit DDV. The timing controller may receive image signals from an external unit, convert data formats of the image signals to satisfy interface specifications with the data driving unit DDV, and provide the converted image signals to the data driving unit DDV.

In an embodiment, the scan driving unit SDV may generate a plurality of scan signals in response to the scan control signal. The scan signals may be applied to the pixels PX through the scan lines SL1 to SLm, where the scan signals may be sequentially applied to the pixels PX.

In an embodiment, the data driving unit DDV may generate a plurality of data voltages corresponding to the image signals in response to the data control signal. The data voltages may be applied to the pixels PX through the data lines DL1 to DLn. The light emitting driving unit EDV may generate a plurality of light emitting signals in response to the light emitting control signal, where the light emitting signals may be applied to the pixels PX through the light emitting lines EL1 to ELm.

In an embodiment, the pixels PX may receive the data voltages in response to the scan signals. The pixels PX may display an image by emitting lights having luminances corresponding to the data voltages in response to the light emitting signals. Light emitting times of the pixels PX may be controlled by the light emitting signals.

In an embodiment, a voltage generating unit (not illustrated) may be disposed on the printed circuit board PCB, where the voltage generating unit may be connected to the pads PD through the printed circuit board PCB. The voltage generating unit may generate a first voltage and a second voltage, where the first voltage and the second voltage may be applied to the first power line PL1 and the second power line PL2, respectively.

Each of the pixels PX may include an organic light emitting element, where the first voltage may be applied to an anode electrode of the organic light emitting element, and the second voltage may be applied to a cathode electrode of the organic light emitting element. The organic light emitting element may operate by receiving the first voltage and the second voltage.

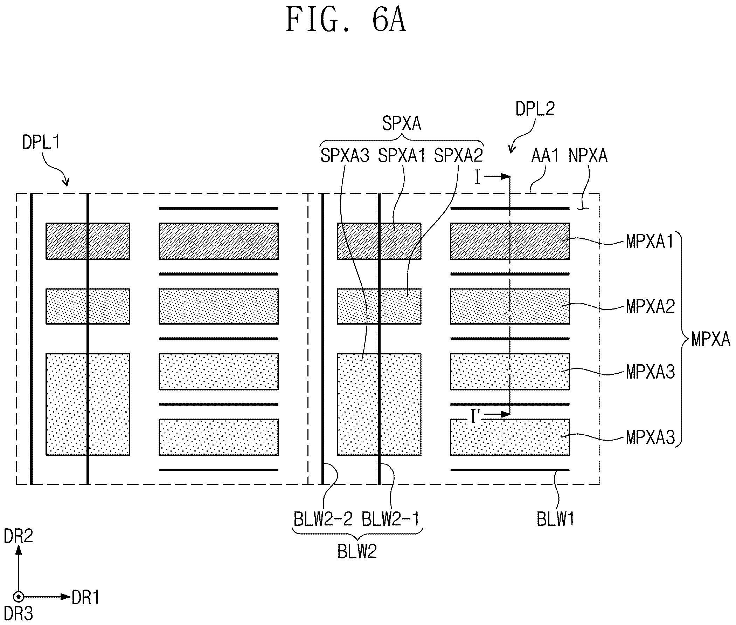

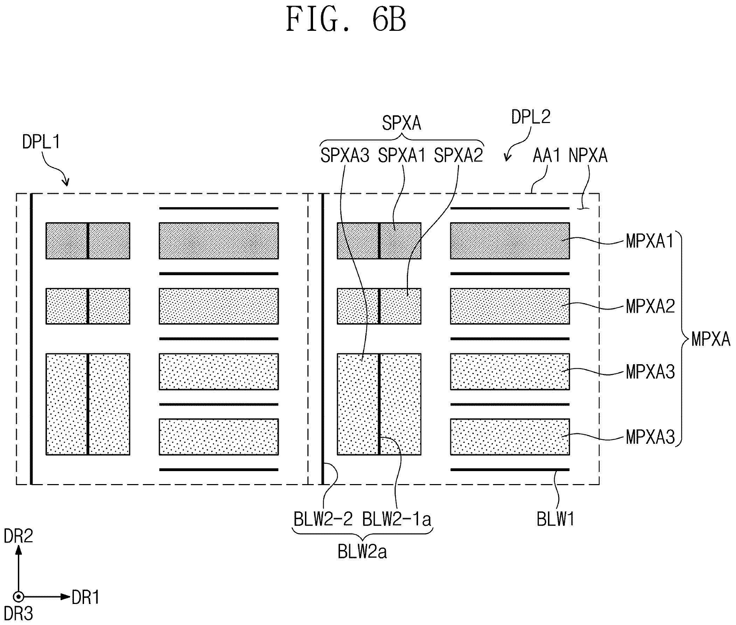

FIGS. 6A and 6B are enlarged plan views of a first area AA1 illustrated in FIG. 5, according to an embodiment.

For convenience of description, FIG. 6B will be described mainly in terms of differences from FIG. 6A.

In an embodiment and referring to FIGS. 6A and 6B, main light emitting areas MPXA and sub-light emitting areas SPXA may be defined on the first display surface DPL1 and the second display surface DPL2. On a plane, the main light emitting areas MPXA and the sub-light emitting areas SPXA may be arranged in the first direction DR1. On a plane, a non-light emitting area NPXA may surround the main light emitting areas MPXA and the sub-light emitting areas SPXA.

As illustrated, the arrangement shape of the main light emitting areas MPXA and the arrangement shape of the sub-light emitting areas SPXA arranged on the first display surface DPL1 may be substantially the same as the arrangement shape of the main light emitting areas MPXA and the arrangement shape of the sub-light emitting areas SPXA arranged on the second display surface DPL2. Hereinafter, for convenience of description, the main light emitting area MPXA and the sub-light emitting area SPXA arranged on the second display surface DPL2 will be mainly described.

In an embodiment, the main light emitting area MPXA may include a first light emitting area MPXA1, a second light emitting area MPXA2, and a plurality of third light emitting areas MPXA3. The first light emitting area MPXA1 may emit a red light, the second light emitting area MPXA2 may emit a green light, and the third light emitting areas MPXA3 may emit a blue light.

As illustrated, the first light emitting area MPXA1, the second light emitting area MPXA2, and the third light emitting areas MPXA3 may be arranged in the second direction DR2. However, the arrangement shape of the first light emitting area MPXA1, the second light emitting area MPXA2, and the third light emitting areas MPXA3 is not limited thereto, and the first light emitting area MPXA1, the second light emitting area MPXA2, and the third light emitting areas MPXA3 may be arranged in various forms.

As illustrated, on a plane, the first light emitting area MPXA1, the second light emitting area MPXA2, and the third light emitting areas MPXA3 may have a rectangular shape having long sides which extend in the first direction DR1 and short sides which extend in the second direction DR2. However, the invention is not limited thereto, and at least one main light emitting area among the first light emitting area MPXA1, the second light emitting area MPXA2, and the third light emitting areas MPXA3 may have a different shape from that of the other main light emitting areas.

As illustrated, on a plane, areas of the first light emitting area MPXA1, the second light emitting area MPXA2, and the third light emitting areas MPXA3 may be the same. However, the invention is not limited thereto, and at least one light emitting area among the first light emitting area MPXA1, the second light emitting area MPXA2, and the third light emitting areas MPXA3 may have a different area from that of the other light emitting areas.

In an embodiment, the sub-light emitting area SPXA may include a first sub-light emitting area SPXA1, a second sub-light emitting area SPXA2, and a third sub-light emitting area SPXA3, where the first sub-light emitting area SPXA1 may emit a red light, the second sub-light emitting area SPXA2 may emit a green light, and the third sub-light emitting area SPXA3 may emit a blue light.

As illustrated, the first sub-light emitting area SPXA1, the second sub-light emitting area SPXA2, and the third sub-light emitting area SPXA3 may be arranged in the second direction DR2. However, the arrangement shape of the first sub-light emitting area SPXA1, the second sub-light emitting area SPXA2, and the third sub-light emitting area SPXA3 is not limited thereto, and the first sub-light emitting area SPXA1, the second sub-light emitting area SPXA2, and the third sub-light emitting area SPXA3 may be arranged in various forms.

As illustrated, on a plane, the first sub-light emitting area SPXA1 and the second sub-light emitting area SPXA2 may have a rectangular shape having long sides extending in the first direction DR1 and short sides extending in the second direction DR2. On a plane, the third sub-light emitting area SPXA3 may have a rectangular shape having short sides extending in the first direction DR1 and long sides extending in the second direction DR2. However, the invention is not limited thereto, and at least one sub-light emitting area among the first sub-light emitting area SPXA1, the second sub-light emitting area SPXA2, and the third sub-light emitting area SPXA3 may have a different shape from that of the other sub-light emitting areas.

As illustrated, on a plane, an area of the first sub-light emitting area SPXA1 and an area of the second sub-light emitting area SPXA2 may be the same. On a plane, an area of the third sub-light emitting area SPXA3 may be larger than the area of the first sub-light emitting area SPXA1 and the second sub-light emitting area SPXA2. However, the invention is not limited thereto, and the area of the third sub-light emitting area SPXA3 may be smaller than the area of the first sub-light emitting area SPXA1 and the second sub-light emitting area SPXA2.

In an embodiment and referring to FIGS. 5 and 6A, the first display surface DPL1 and the second display surface DPL2 of the display surface DPL may be driven in a first mode. When the first display surface DPL1 and the second display surface DPL2 are driven in the first mode, the pixels PX (see FIG. 5) arranged on the first display surface DPL1 and the second display surface DPL2 may be driven.

The second display surface DPL2 may be driven in a second mode. The first display surface DPL1 may not be driven in the second mode. When the second display surface DPL2 is driven in the second mode, the pixels PX (see FIG. 5) arranged on the second display surface DPL2 may be driven. When the second display surface DPL2 is driven in the second mode, a light may be emitted from the sub-light emitting area SPXA disposed on the second display surface DPL2. When the second display surface DPL2 is driven in the second mode, a light may not be emitted from the main light emitting area MPXA disposed on the second display surface DPL2.

In an embodiment, the first display surface DPL1 and the second display surface DPL2 may be driven independently of each other. As illustrated, when the vehicle VH (see FIG. 1) operates, the first display surface DPL1 may be driven in the first mode, and the second display surface DPL2 may be driven in the second mode. When the vehicle VH (see FIG. 1) is stopped, the first display surface DPL1 and the second display surface DPL2 may be driven in the first mode.

In an embodiment, the display device DD (see FIG. 2) may include a plurality of first partition walls BLW1 and a plurality of second partition walls BLW2. The first partition walls BLW1 may be arranged on the non-light emitting area NPXA and may be arranged between the main light emitting areas MPXA. The first partition walls BLW1 may be arranged to be adjacent to both sides of each of the first light emitting area MPXA1, the second light emitting area MPXA2, and the third light emitting areas MPXA3, which are disposed opposite to each other in the second direction DR2. On a plane, the first partition walls BLW1 may extend in the first direction DR1 and may be arranged between the first light emitting area MPXA1 and the second light emitting area MPXA2, between the second light emitting area MPXA2 and the third light emitting areas MPXA3, and between the third light emitting areas MPXA3.

The first partition walls BLW1 may be made of a resin containing a black material. Illustratively, the first partition walls BLW1 may be made of polycarbonate.

The first partition walls BLW1 may shield a portion of a light emitted from the main light emitting area MPXA. The portion of the light emitted from the main light emitting area MPXA may not travel in the second direction DR2 and a direction which is opposite to the second direction DR2 due to the first partition walls BLW1.

In an embodiment and referring to FIGS. 1 and 6A, when the light emitted from the main light emitting area MPXA travels toward the front window FWI, the image displayed on the display device DD may be focused on the front window FWI. Accordingly, the driver may not recognize an object in front of the vehicle VH, which may interfere with the operation of the vehicle VH.

As the first partition walls BLW1 shield the portion of the light emitted from the main light emitting area MPXA, the image displayed on the display device DD may not travel toward the front window FWI. In another embodiment, the light emitted from the display device DD may travel to the front window FWI at a relatively small ratio. Accordingly, the image displayed on the display device DD may not be focused on the front window FWI. Thus, it is possible to prevent the driver from being disturbed when the driver operates the vehicle VH.

In an embodiment and referring to FIG. 6A, the second partition walls BLW2 may extend on the second display surface DPL2 in the second direction DR2 and may be arranged on the non-light emitting area NPXA and the sub-light emitting area SPXA.

The second partition walls BLW2 may include a (2-1)^{th} partition wall BLW2-1 and a (2-2)^{th} partition wall BLW2-2, where the (2-1)^{th} partition wall BLW2-1 may overlap the sub-light emitting area SPXA and the (2-2)^{th} partition wall BLW2-2 may not overlap the sub-light emitting area SPXA.

The (2-1)^{th} partition wall BLW2-1 may extend on the second display surface DPL2 in the second direction DR2, where a portion of the (2-1)^{th} partition wall BLW2-1 may overlap the sub-light emitting area SPXA and the other portion of (2-1)^{th} partition wall BLW2-1 may overlap the non-light emitting area NPXA.

The (2-2)^{th} partition wall BLW2-2 may extend on the second display surface DPL2 in the second direction DR2 and may be disposed on the non-light emitting area NPXA.

The second partition walls BLW2 may shield a portion of the light emitted from the sub-light emitting area SPXA, where the portion of the light emitted from the sub-light emitting area SPXA may not travel in a direction opposite to the first direction DR1 due to the second partition walls BLW2.

In an embodiment and referring to FIGS. 1 and 6A, when the driver operates the vehicle VH, the second display surface DPL2 may be driven in the second mode. When the image provided in the second area DA2 is visually recognized by the driver, the image may disturb the driver. Accordingly, when this occurs, the operation of the vehicle VH may be unsafe.

When the vehicle VH operates, a light emitted from the sub-light emitting areas SPXA may not travel toward the driver due to the second partition walls BLW2. In another embodiment, the light emitted from the sub-light emitting areas SPXA may travel toward the driver at a relatively small ratio due to the second partition walls BLW2. Accordingly, it is possible to prevent the image displayed in the second area DA2 from being visually recognized by the driver. Thus, it is possible to prevent the driver from being disturbed when the driver operates the vehicle VH.

Referring to FIG. 6B, a (2-1)^{th} partition wall BLW2-1a may overlap the sub-light emitting area SPXA. On a plane, the (2-1)^{th} partition wall BLW2-1a may extend on the sub-light emitting area SPXA in the second direction DR2 and may not be disposed on the non-light emitting area NPXA.

The (2-2)^{th} partition wall BLW2-2 may be disposed on the non-light emitting area NPXA and may extend on the non-light emitting area NPXA in the second direction DR2.

The light emitted from the sub-light emitting area SPXA may not travel in the second direction DR2 due to the second partition walls BLW2.

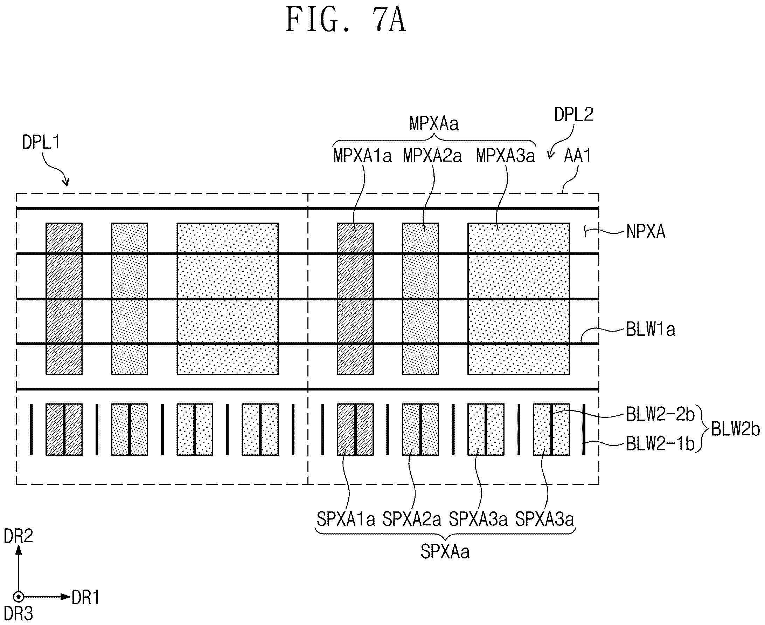

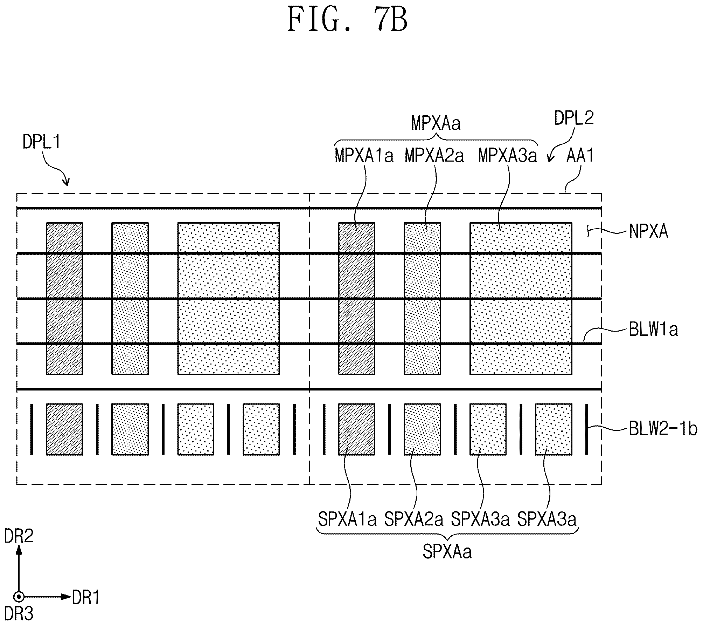

FIGS. 7A and 7B are enlarged plan views of a first display surface and a second display surface, according to an embodiment.

As illustrated, FIGS. 7A and 7B are enlarged plan views of an area corresponding to the first area AA1 illustrated in FIG. 5.

Since the non-light emitting area NPXA of the FIGS. 7A and 7B is the same as the non-light emitting area NPXA of FIG. 6A, a description thereof will be omitted or simplified.

For convenience of description, FIGS. 7A and 7B will be described mainly in terms of differences from FIG. 6A.

In an embodiment and referring to FIGS. 7A and 7B, main light emitting areas MPXAa and sub-light emitting areas SPXAa may be defined on the first display surface DPL1 and the second display surface DPL2. On a plane, the main light emitting areas MPXAa and the sub-light emitting areas SPXAa may be arranged in the second direction DR2. On a plane, the non-light emitting area NPXA may surround the main light emitting areas MPXAa and the sub-light emitting areas SPXAa.

As illustrated, the arrangement shape of the main light emitting areas MPXAa and the arrangement shape of the sub-light emitting areas SPXAa arranged on the first display surface DPL1 may be substantially the same as the arrangement shape of the main light emitting areas MPXAa and the arrangement shape of the sub-light emitting areas SPXAa arranged on the second display surface DPL2. Hereinafter, for convenience of description, the main light emitting area MPXAa and the sub-light emitting area SPXAa arranged on the second display surface DPL2 will be mainly described.

In an embodiment, the main light emitting area MPXAa may include a first light emitting area MPXA1a, a second light emitting area MPXA2a, and a third light emitting area MPXA3a. As shown, the first light emitting area MPXA1a, the second light emitting area MPXA2a, and the third light emitting area MPXA3a may be arranged in the first direction DR1.

As shown, on a plane, the first light emitting area MPXA1a, the second light emitting area MPXA2a, and the third light emitting area MPXA3a may have a rectangular shape having short sides extending in the first direction DR1 and long sides extending in the second direction DR2. However, the invention is not limited thereto, and at least one main light emitting area among the first light emitting area MPXA1a, the second light emitting area MPXA2a, and the third light emitting area MPXA3a may have a different shape from that of the other main light emitting areas.

Moreover, an area of the first light emitting area MPXA1a and an area of the second light emitting area MPXA2a may be the same. An area of the third light emitting area MPXA3a may be larger than the area of the first light emitting area MPXA1a and the area of the second light emitting area MPXA2a.

In an embodiment, the sub-light emitting area SPXAa may include a first sub-light emitting area SPXA1a, a second sub-light emitting area SPXA2a, and a plurality of third sub-light emitting areas SPXA3a. As shown, the first sub-light emitting area SPXA1a, the second sub-light emitting area SPXA2a, and the plurality of third sub-light emitting areas SPXA3a may be arranged in the first direction DR1.

The first sub-light emitting area SPXA1a and the first light emitting area MPXA1a may be arranged in the second direction DR2. The second sub-light emitting area SPXA2a and the second light emitting area MPXA2a may be arranged in the second direction DR2. The third sub-light emitting areas SPXA3a and the third light emitting area MPXA3a may be arranged in the second direction DR2.

As shown, on a plane, the first sub-light emitting area SPXA1a, the second sub-light emitting area SPXA2a, and the third sub-light emitting areas SPXA3a may have a rectangular shape and areas of the first sub-light emitting area SPXA1a, the second sub-light emitting area SPXA2a, and the third sub-light emitting areas SPXA3a may be the same.

In an embodiment, first partition walls BLW1a may be arranged on the second display surface DPL2. The first partition walls BLW1a may extend on the second display surface DPL2 in the first direction DR1 and may be arranged in the second direction DR2, where some of the first partition walls BLW1a may overlap the main light emitting area MPXAa.

The first partition walls BL W1a may shield a portion of a light emitted from the main light emitting area MPXAa. The portion of the light emitted from the main light emitting area MPXAa may not travel in the second direction DR2 and a direction opposite to the second direction DR2 due to the first partition walls BLW1a.

The light emitted from the main light emitting area MPXAa may not travel toward the front window FWI (see FIG. 1). Accordingly, the image displayed on the display device DD (see FIG. 1) may not be focused on the front window FWI (see FIG. 1). Thus, it is possible to prevent the driver from being disturbed when the driver operates the vehicle VH.

In an embodiment and as illustrated in FIG. 7A, second partition walls BLW2b may be arranged on the second display surface DPL2 and may include (2-1)^{th} partition walls BLW2-1b and (2-2)^{th} partition walls BLW2-2b. The (2-1)^{th} partition walls BLW2-1b may be arranged between the sub-light emitting areas SPXAa disposed adjacent to each other in the first direction DR1 and the (2-2)^{th} partition walls BLW2-2b may overlap the sub-light emitting areas SPXAa. However, this is merely illustrative, and as illustrated in FIG. 7B, in another embodiment, the (2-2)^{th} partition walls BLW2-2b may be omitted. Hereinafter, an embodiment in which the second partition walls BLW2b includes the (2-1)^{th} partition walls BLW2-1b and the (2-2)^{th} partition walls BLW2-2b will be described.

The second partition walls BLW2b may extend on the second display surface DPL2 in the second direction DR2 and may be arranged in the first direction DR1. As illustrated in FIG. 7A, the (2-1)^{th} partition walls BLW2-1b and the (2-2)^{th} partition walls BLW2-2b may be alternately arranged in the first direction DR1.

The second partition walls BLW2b may shield a portion of a light emitted from the sub-light emitting area SPXAa such that the light emitted from the sub-light emitting area SPXAa may not travel in a direction opposite to the first direction DR1. Accordingly, when the second display surface DPL2 is driven in the second mode, the image provided in the second area DA2 (see FIG. 1) may not be visually recognized by the driver. Thus, it is possible to prevent the driver from being disturbed when the driver operates the vehicle VH.

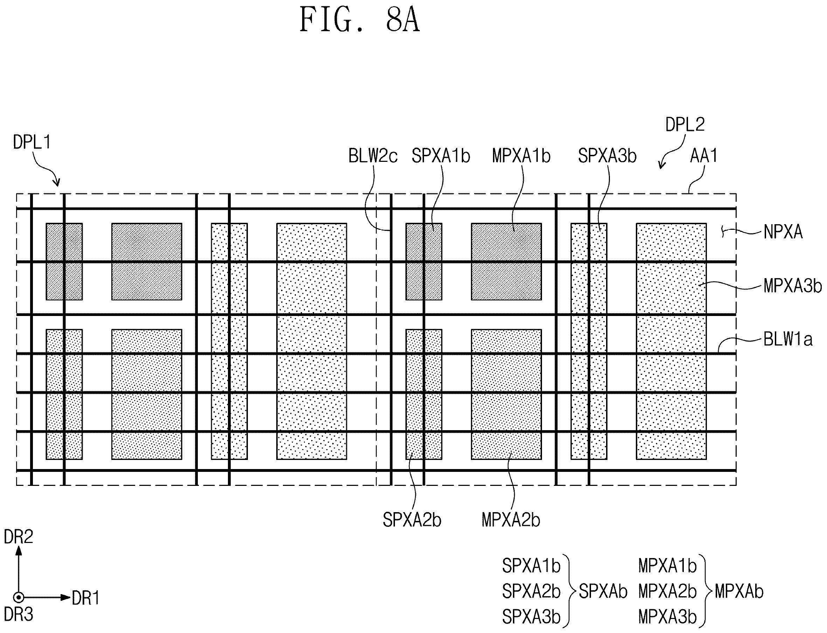

FIGS. 8A to 8C are enlarged plan views of the first display surface and the second display surface, according to an embodiment.

As shown, FIGS. 8A to 8C are enlarged plan views of an area corresponding to the first area AA1 illustrated in FIG. 5.

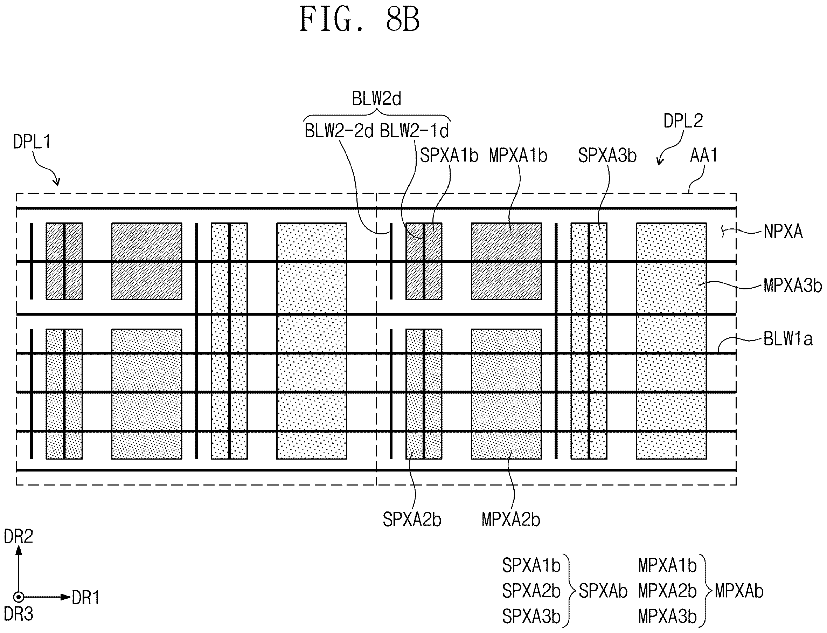

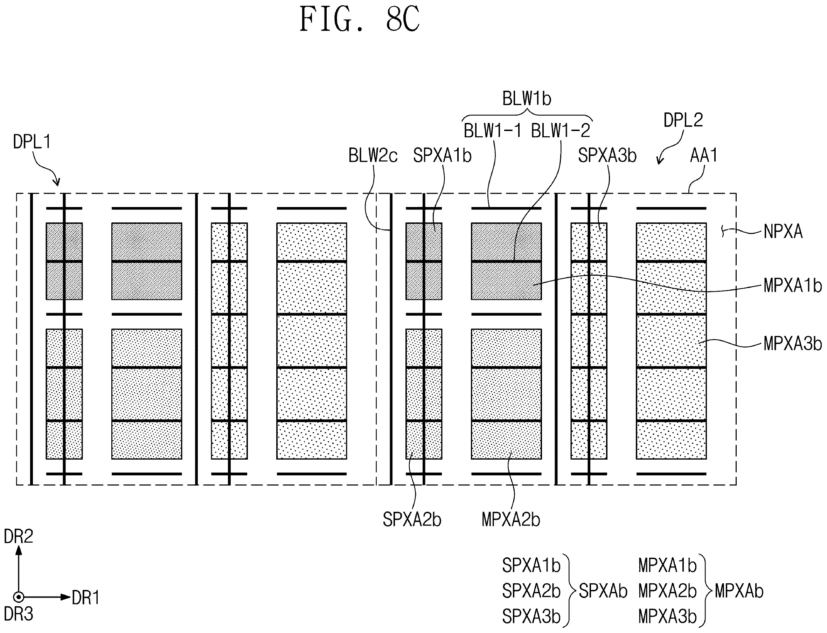

For convenience of description, FIGS. 8B and 8C will be described mainly in terms of differences from FIG. 8A.

In an embodiment and referring to FIGS. 8A to 8C, main light emitting areas MPXAb and sub-light emitting areas SPXAb may be defined on the first display surface DPL1 and the second display surface DPL2. As shown, the arrangement shape of the main light emitting areas MPXAb and the arrangement shape of the sub-light emitting areas SPXAb arranged on the first display surface DPL1 may be substantially the same as the arrangement shape of the main light emitting areas MPXAb and the arrangement shape of the sub-light emitting areas SPXAb arranged on the second display surface DPL2. Hereinafter, for convenience of description, the main light emitting area MPXAb and the sub-light emitting area SPXAb arranged on the second display surface DPL2 will be mainly described.

In an embodiment, the main light emitting area MPXAb may include a first light emitting area MPXA1b, a second light emitting area MPXA2b, and a third light emitting area MPXA3b, where the first light emitting area MPXA1b and the second light emitting area MPXA2b may be arranged in the second direction DR2, the first light emitting area MPXA1b and the third light emitting area MPXA3b may be arranged in the first direction DR1 the second light emitting area MPXA2b and the third light emitting area MPXA3b may be arranged in the first direction DR1.

On a plane, the first light emitting area MPXA1b, the second light emitting area MPXA2b, and the third light emitting area MPXA3b may have a rectangular shape having long sides extending in the second direction DR2 and short sides extending in the first direction DR1. On a plane, an area of the second light emitting area MPXA2b may be larger than an area of the first light emitting area MPXA1b and the area of the second light emitting area MPXA2b may be smaller than an area of the third light emitting area MPXA3b.

In an embodiment, the sub-light emitting area SPXAb may include a first sub-light emitting area SPXA1b, a second sub-light emitting area SPXA2b, and a third sub-light emitting area SPXA3b, where the first sub-light emitting area SPXA1b and the second sub-light emitting area SPXA2b may be arranged in the second direction DR2 and the third sub-light emitting area SPXA3b may be spaced apart from the first and second sub-light emitting areas SPXA1b and SPXA2b in the first direction DR1.

The first sub-light emitting area SPXA1b and the first light emitting area MPXA1b may be arranged in the first direction DR1. The first sub-light emitting area SPXA1b may be disposed on one side among both sides of the first light emitting area MPXA1b, which are disposed opposite to each other in the first direction DR1.

The second sub-light emitting area SPXA2b and the second light emitting area MPXA2b may be arranged in the first direction DR1, where the second sub-light emitting area SPXA2b may be disposed on one side among both sides of the second light emitting area MPXA2b, which are disposed opposite to each other in the first direction DR1.

The third sub-light emitting area SPXA3b and the third light emitting area MPXA3b may be arranged in the first direction DR1, where the third sub-light emitting area SPXA3b may be disposed on one side among both sides of the third light emitting area MPXA3b, which are disposed opposite to each other in the first direction DR1. A portion of the third sub-light emitting area SPXA3b may be disposed between the first light emitting area MPXA1b and the third light emitting area MPXA3b. Another portion of the third sub-light emitting area SPXA3b may be disposed between the second light emitting area MPXA2b and the third light emitting area MPXA3b.

On a plane, the first sub-light emitting area SPXA1b, the second sub-light emitting area SPXA2b, and the third sub-light emitting area SPXA3b may have a rectangular shape having short sides extending in the first direction DR1 and long sides extending in the second direction DR2. On a plane, an area of the second sub-light emitting area SPXA2b may be larger than an area of the first sub-light emitting area SPXA1b and the area of the second sub-light emitting area SPXA2b may be smaller than an area of the third sub-light emitting area SPXA3b.

In an embodiment and referring to FIGS. 1 and 8A, the first partition walls BLW1a may be arranged on the first and second display surfaces DPL1 and DPL2. The first partition walls BLW1a may extend on the first and second display surfaces DPL1 and DPL2 in the first direction DR1. Some of the first partition walls BLW1a may be arranged on the main light emitting areas MPXAb and the sub-light emitting areas SPXAb. Some of the first partition walls BLW1a may overlap the main light emitting areas MPXAb and the sub-light emitting areas SPXAb.

The first partition walls BLW1a may shield portions of lights emitted from the main light emitting areas MPXAb and the sub-light emitting areas SPXAb. The portions of the lights emitted from the main light emitting areas MPXAb and the sub-light emitting areas SPXAb may not travel in the second direction DR2 and a direction opposite to the second direction DR2 due to the first partition walls BLW1a. Accordingly, the image provided from the display device DD may not be projected onto the front window FWI.

Additionally, the second partition walls BLW2c may be arranged on the first and second display surfaces DPL1 and DPL2, where the second partition walls BLW2c may extend on the first and second display surfaces DPL1 and DPL2 in the second direction DR2. Some of the second partition walls BLW2c may be arranged on the sub-light emitting area SPXAb and some of the second partition walls BLW2c may overlap the sub-light emitting area SPXAb.

The second partition walls BLW2c may shield a portion of a light emitted from the sub-light emitting area SPXAb. Thus, the portion of the light emitted from the sub-light emitting area SPXAb may not travel in a direction opposite to the first direction DR1 due to the second partition walls BLW2c. Accordingly, it is possible to prevent the image provided in the second area DA2 of the display device DD from being visually recognized by the driver.

In an embodiment and referring to FIG. 8B, second partition walls BLW2d may include (2-1)^{th} partition walls BLW2-1d and (2-2)^{th} partition walls BLW2-2d. The (2-2)^{th} partition walls BLW2-2d may be arranged on the non-light emitting area NPXA and may extend on the non-light emitting area NPXA in the second direction DR2. Additionally, the (2-2)^{th} partition walls BLW2-2d may be arranged on one side among both sides of each of the first sub-light emitting area SPXA1b, the second sub-light emitting area SPXA2b, and the third sub-light emitting area SPXA3b, which are disposed opposite to each other in the first direction DR1.

The (2-1)^{th} partition walls BL W2-1d may be arranged on the sub-light emitting areas SPXAb and may overlap the sub-light emitting areas SPXAb. Additionally, the (2-1)^{th} partition walls BLW2-1d may extend on the sub-light emitting areas SPXAb in the second direction DR2.

As shown, a length of the (2-2)^{th} partition walls BLW2-2d in the second direction DR2 may be the same as a length of the sub-light emitting areas SPXAb disposed adjacent to the (2-2)^{th} partition walls BLW2-2d in the second direction DR2. A length of the (2-1)^{th} partition walls BLW2-1d in the second direction DR2 may be the same as a length of the sub-light emitting areas SPXAb overlapping the (2-1)^{th} partition walls BLW2-1d in the second direction DR2.

In an embodiment and referring to FIG. 8C, first partition walls BLW1b may include a plurality of (1-1)^{th} partition walls BLW1-1 and a plurality of (1-2)^{th} partition walls BLW1-2, where the (1-1)^{th} partition walls BLW1-1 may be arranged on the non-light emitting area NPXA. The (1-1)^{th} partition walls BLW1-1 may be arranged to be adjacent to the main light emitting areas MPXAb and the sub-light emitting areas SPXAb. The (1-1)^{th} partition walls BLW1-1 may also be arranged to be adjacent to both sides of the main light emitting areas MPXAb and the sub-light emitting areas SPXAb, which are disposed opposite to each other in the second direction DR2.

The (1-1)^{th} partition walls BLW1-1 may extend on the non-light emitting area NPXA in the first direction DR1. As shown, a length of the (1-1)^{th} partition walls BLW1-1 in the first direction DR1 may be the same as a length of the main light emitting areas MPXAb or the sub-light emitting areas SPXAb to be adjacent to the (1-1)^{th} partition walls BLW1-1 in the first direction DR1.

The (1-2)^{th} partition walls BLW1-2 may be arranged on the main light emitting areas MPXAb and the sub-light emitting areas SPXAb and may overlap the main light emitting areas MPXAb and the sub-light emitting areas SPXAb.

As shown, a length of the (1-2)^{th} partition walls BLW1-2 in the first direction DR1 may be the same as a length of the main light emitting areas MPXAb or the sub-light emitting areas SPXAb respectively corresponding to the (1-2)^{th} partition walls BLW1-2 in the first direction DR1.

FIGS. 9A to 9D are cross-sectional views of the display device, according to an embodiment.

As shown, the window WM, the light control layer LCL, and the display panel DP, and the panel protecting layer PPL corresponding to line I-I' illustrated in FIG. 6A are shown in FIGS. 9A to 9D.

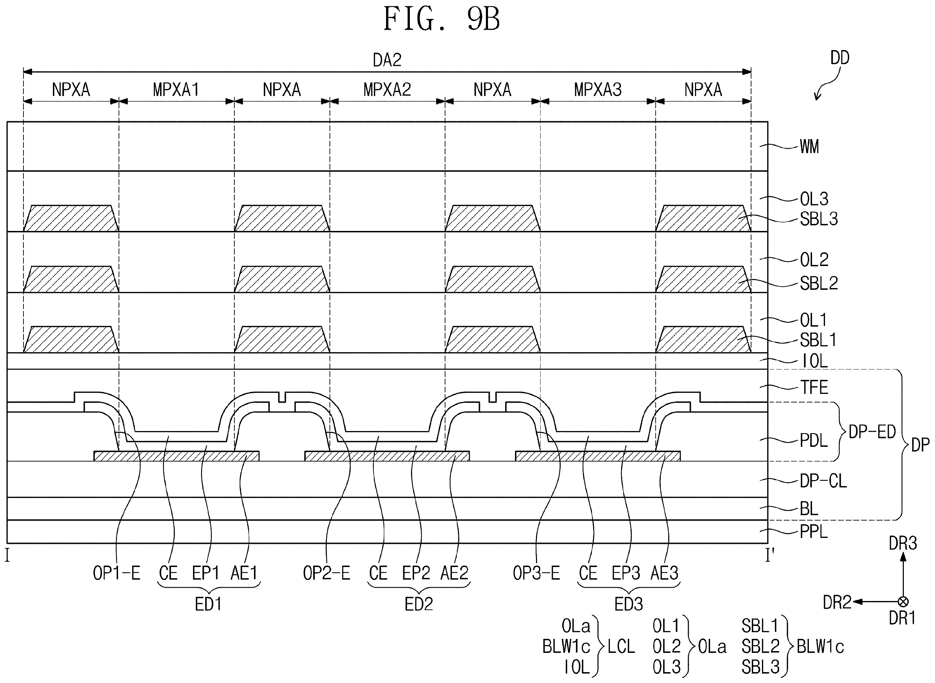

For convenience of description, FIGS. 9B to 9D will be described mainly in terms of differences from FIG. 9A.

Since the window WM and the panel protecting layer PPL illustrated in FIGS. 9A to 9D is substantially the same as the window WM and the panel protecting layer PPL in FIG. 3, a description thereof will be omitted or simplified.

In an embodiment and referring to FIGS. 9A to 9D, the display panel DP may include first to third light emitting elements ED1, ED2, and ED3, respectively. The first light emitting element ED1 may include a first anode AE1, a first light emitting pattern EP1, and a portion of a cathode CE. The second light emitting element ED2 may include a second anode AE2, a second light emitting pattern EP2, and a portion of the cathode CE. The third light emitting element ED3 may include a third anode AE3, a third light emitting pattern EP3, and a portion of the cathode CE.

The first to third anodes AE1, AE2, and AE3, respectively, may be provided in a plurality of patterns. First to third light emitting openings OP1-E, OP2-E, and OP3-E may be defined in a pixel defining film PDL, where the first light emitting opening OP1-E may expose at least a portion of the first anode AE1, the second light emitting opening OP2-E may expose at least a portion of the second anode AE2 and the third light emitting opening OP3-E may expose at least a portion of the third anode AE3. Additionally, the first light emitting openings OP1-E may define the first light emitting areas MPXA1, the second light emitting openings OP2-E may define the second light emitting areas MPXA2 and the third light emitting openings OP3-E may define the third light emitting areas MPXA3. The first to third light emitting areas MPXA1, MPXA2, and MPXA3, respectively, may be areas in which lights generated by the first to third light emitting elements ED1, ED2, and ED3, respectively, are emitted to the outside.

The first light emitting pattern EP1, the second light emitting pattern EP2 and the third light emitting pattern EP3 may be arranged to be disposed on the first anode AE1, the second anode AE2 and the third anode AE3, respectively, and the pixel defining film PDL. Additionally, the first light emitting pattern EP1, the second light emitting pattern EP2 and the third light emitting pattern EP3 may be arranged in the first light emitting opening OP1-E, the second light emitting opening OP2-E and the third light emitting opening OP3-E, respectively. The first light emitting pattern EP1 may be disposed in the first light emitting opening OP1-E, the second light emitting pattern EP2 may be disposed in the second light emitting opening OP2-E, and the third light emitting pattern EP3 may be disposed in the third light emitting opening OP3-E.

The light emitting patterns EP1, EP2, and EP3 may provide light of different colors. For example, the first light emitting pattern EP1 may provide a red light, the second light emitting pattern EP2 may provide a green light, and the third light emitting pattern EP3 may provide a blue light.

The cathode CE may be disposed on the light emitting patterns EP1, EP2, and EP3 and on the pixel defining film PDL.

Additionally, the encapsulation layer TFE may be disposed on a display element layer DP-ED and may protect the display emitting element layer DP-ED from foreign substances such as moisture, oxygen, and dust particles. The encapsulation layer TFE may include an inorganic layer, an organic layer, and an inorganic layer that are sequentially laminated, but layers constituting the encapsulation layer TFE are not limited thereto.

In an embodiment and referring to FIG. 9A, the light control layer LCL may be disposed on the display panel DP and on an upper surface of the encapsulation layer TFE. The light control layer LCL may include a control inorganic layer IOL, the first partition walls BLW1, and a control organic layer OL.

The control inorganic layer IOL may be disposed on the upper surface of the encapsulation layer TFE and may include at least one of an aluminum oxide, a titanium oxide, a silicon oxide, a silicon nitride, a silicon oxy nitride, a zirconium oxide, or a hafnium oxide.

The first partition walls BLW1 may be arranged on the control inorganic layer IOL. The first partition walls BLW1 may be arranged on an upper surface of the control inorganic layer IOL. The first partition walls BLW1 may be arranged in the second direction DR2 on the control inorganic layer IOL and the first partition walls BLW1 may be arranged to overlap the pixel defining film PDL.

A distance between the first partition walls BLW1 spaced apart from each other in the second direction DR2 may be defined as a first length L1 and a length of the first partition walls BLW1 in the third direction DR3 may be defined as a second length L2. The second length L2 may be greater than the first length L1. As shown, a ratio between the first length L1 and the second length L2 may be in a range of about 1:2 to about 1:3.

The first partition walls BLW1 may be made of a resin containing a black material. As shown, the first partition walls BLW1 may be made of polycarbonate and may shield portions of lights emitted from the light emitting elements ED1, ED2, and ED3.

Although not illustrated, a structure of the second partition walls BLW2 (see FIG. 6A) may be substantially the same as a structure of the first partition walls BLW1.

The control organic layer OL may be disposed on the control inorganic layer IOL and the first partition walls BLW1, where the control organic layer OL may seal the first partition walls BLW1 on the control inorganic layer IOL. A portion of the control organic layer OL may be disposed on the upper surface of the control inorganic layer IOL.

The window WM may be disposed on the light control layer LCL. The window WM may be disposed on an upper surface of the control organic layer OL and may protect the display panel DP and the light control layer LCL from external scratches and impacts.

In an embodiment and referring to FIG. 9B, a control organic layer OLa may include a first organic layer OL1, a second organic layer OL2, and a third organic layer OL3, where the first organic layer OL1, the second organic layer OL2, and the third organic layer OL3 may be sequentially laminated.

Each of first partition walls BLW1c may include first sub-partition walls SBL1, second sub-partition walls SBL2, and third sub-partition walls SBL3. The first sub-partition walls SBL1, the second sub-partition walls SBL2, and the third sub-partition walls SBL3 may be made of a resin containing a black material. As shown, the first sub-partition walls SBL1, the second sub-partition walls SBL2, and the third sub-partition walls SBL3 may be made of polycarbonate. The first sub-partition walls SBL1, the second sub-partition walls SBL2, and the third sub-partition walls SBL3 may shield the portions of the lights emitted from the light emitting elements ED1, ED2, and ED3, respectively.

The first sub-partition walls SBL1 may be arranged on the upper surface of the control inorganic layer IOL and may be arranged in the second direction DR2. Additionally, the first sub-partition walls SBL1 may be arranged to overlap the pixel defining film PDL.

The first organic layer OL1 may be disposed on the control inorganic layer IOL and the first sub-partition walls SBL1. The first organic layer OL1 may be disposed on the upper surface of the control inorganic layer IOL and may seal the first sub-partition walls SBL1.

The second sub-partition walls SBL2 may be arranged on an upper surface of the first organic layer OL1 and may be arranged in the second direction DR2. The second sub-partition walls SBL2 may overlap the first sub-partition walls SBL1.

The second organic layer OL2 may be disposed on the first organic layer OL1 and the second sub-partition walls SBL2. The second organic layer OL2 may be disposed on the upper surface of the first organic layer OL1 and may seal the second sub-partition walls SBL2.

The third sub-partition walls SBL3 may be arranged on an upper surface of the second organic layer OL2 and may be arranged in the second direction DR2. The third sub-partition walls SBL3 may overlap the second sub-partition walls SBL2.

The third organic layer OL3 may be disposed on the second organic layer OL2 and the third sub-partition walls SBL3. The third organic layer OL3 may be disposed on the upper surface of the second organic layer OL2 and may seal the third sub-partition walls SBL3.

Although not illustrated, a structure of the second partition walls BLW2 (see FIG. 6A) may be substantially the same as a structure of the first partition walls BLW1c. Further, although not illustrated, the display device DD may include at least one inorganic layer, and the inorganic layer together with the control inorganic layer IOL and the first to third organic layers OL1, OL2, and OL3, respectively, may be alternately laminated in the third direction DR3.

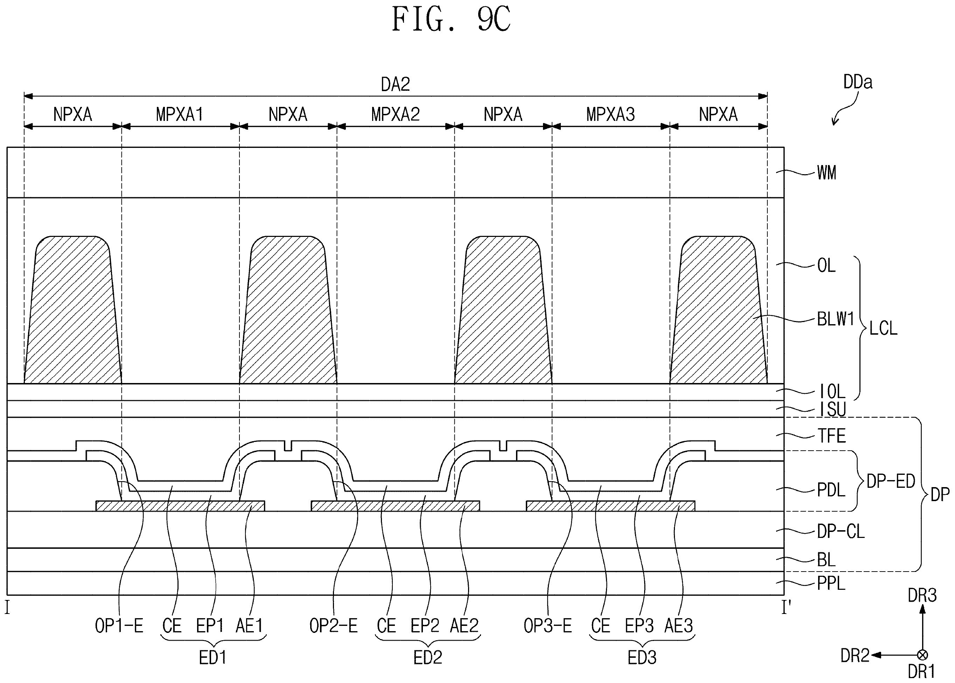

In an embodiment and referring to FIG. 9C, a display device DDa may further include an input sensor ISU, where the light control layer LCL may be disposed on the input sensor ISU and the input sensor ISU may be disposed on the display panel DP. The input sensor ISU may be disposed between the light control layer LCL and the display panel DP.

The input sensor ISU may include any one of a capacitive sensor, an optical sensor, an ultrasonic sensor, and an electromagnetic induction sensor. The input sensor ISU may be formed on the display panel DP through a continuous process or may be separately manufactured and then attached to an upper portion of the display panel DP through an adhesive layer, and the invention is not limited to such an embodiment. The input sensor ISU may overlap the light control layer LCL on a plane.

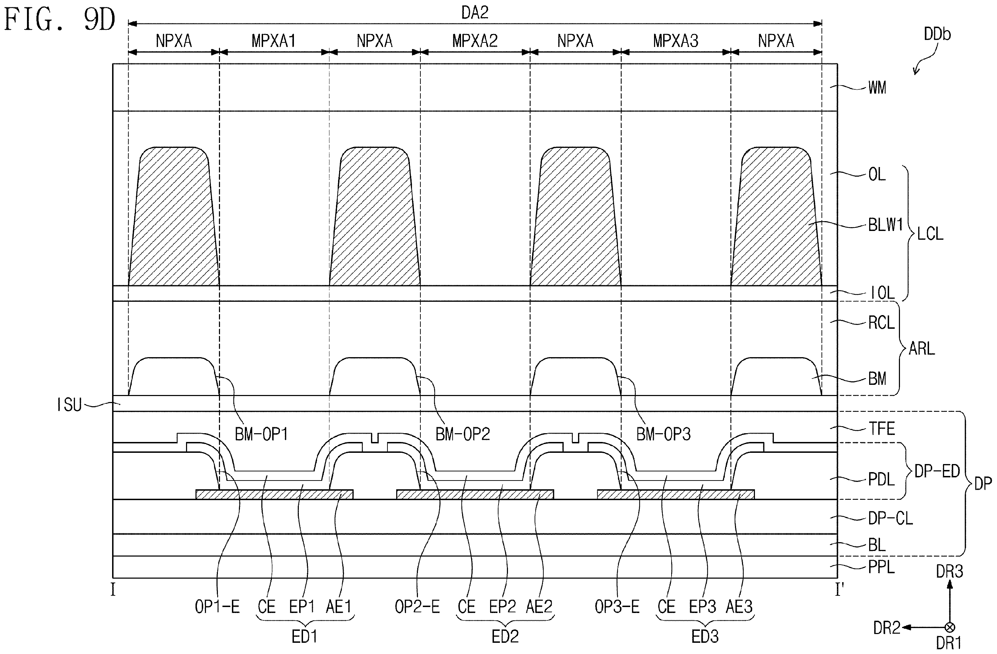

In an embodiment and referring to FIG. 9D, a display device DDb may further include a reflection preventing layer ARL, where the reflection preventing layer ARL may be disposed on an upper surface of the input sensor ISU. The reflection preventing layer ARL may be disposed between the input sensor ISU and the light control layer LCL.

The reflection preventing layer ARL may include a light shielding pattern BM and a cover layer RCL, where the cover layer RCL may fill a space between the light shielding patterns BM which are spaced apart from each other.

A dye and a pigment included in the cover layer RCL may be a material that transmits only a light in a specific wavelength range among the lights emitted from the light emitting elements ED1, ED2, and ED3. In an embodiment, the dye and the pigment may be a material that absorbs a light having a wavelength in a range of about 490 nm to about 505 nm and a light having a wavelength in a range of about 585 nm to about 600 nm and transmit the other lights. As the dye and the pigment included in the cover layer RCL absorb the light having a specific wavelength and transmits the other light having other wavelengths, reflection by an external light may be prevented, and a color sense of the light emitted from the display panel DP may be adjusted.

The dye and the pigment included in the cover layer RCL may include at least one selected from the group consisting of an anthraquinone-based compound, a phtalocyanine-based compound, an azo-based compound, a perylene-based compound, an Xanthene-based compound, a diimmonium-based compound, dipyrromethene-based compound, a tetraazaporphyrin-based compound, a porphyrin-based compound, a squarylium-based compound, an oxazine-based compound, a triarylmethane-based compound and a cyanine-based compound. For example, the cover layer RCL may include any one of a tetraazaporphyrin-based compound, a cyanine-based compound, a squarylium-based compound, and an oxazine-based compound or a combination thereof. The cover layer RCL may contain about 0.01 wt% or more and about 5.00 wt% or less of the dye and the pigment with respect to the total weight of the cover layer RCL. When the cover layer RCL contains less than about 0.01 wt% of the dye and the pigment, the light in the specific wavelength range is not sufficiently absorbed, and thus color reproducibility may not be improved. When the cover layer RCL contains more than about 5.00 wt% of the dye and the pigment, aggregation of the dye and the pigment may occur.

The light shielding pattern BM may be disposed on the input sensor ISU and may be a layer having black color, and in an embodiment, the light shielding pattern BM may include a black coloring agent. The black coloring agent may include black dye and black pigment. The black coloring agent may include carbon black, a metal such as chromium, or an oxide thereof. However, this is merely illustrative, and a material constituting the light shielding pattern BM is not limited as long as the material absorbs a light.

The light shielding pattern BM may be disposed to overlap the pixel defining film PDL. First to third openings BM-OP1, BM-OP2, and BM-OP3, respectively, may be defined in the light shielding pattern BM, where the first opening BM-OP1, the second opening BM-OP2 and the third opening BM-OP3 of the light shielding pattern BM may overlap the first light emitting opening OP1-E, the second light emitting opening OP2-E and the third light emitting opening OP3-E of the pixel defining film PDL, respectively. Thus, the first opening BM-OP1 may overlap the first light emitting opening OP1-E, the second opening BM-OP2 may overlap the second light emitting openings OP2-E, and the third opening BM-OP3 may overlap the third light emitting openings OP3-E.

The first opening BM-OP1, the second opening BM-OP2 and the third opening BM-OP3 of the light shielding pattern BM may define the first light emitting area MPXA1, the second light emitting area MPXA2 and the third light emitting area MPXA3. The first light emitting area MPXA1, the second light emitting area MPXA2 and the third light emitting areas MPXA1, MPXA2, and MPXA3 may be defined as areas in which the lights generated by the first light emitting element ED1, the second light emitting element ED2 and the third light emitting element ED3, respectively, are emitted to the outside.

Although not illustrated, a laminated structure of the display devices DD, DDa, DDb which corresponds to the first area DA1, may be substantially the same as a laminated structure of the display devices DD, DDa, DDb which corresponds to the second area DA2.

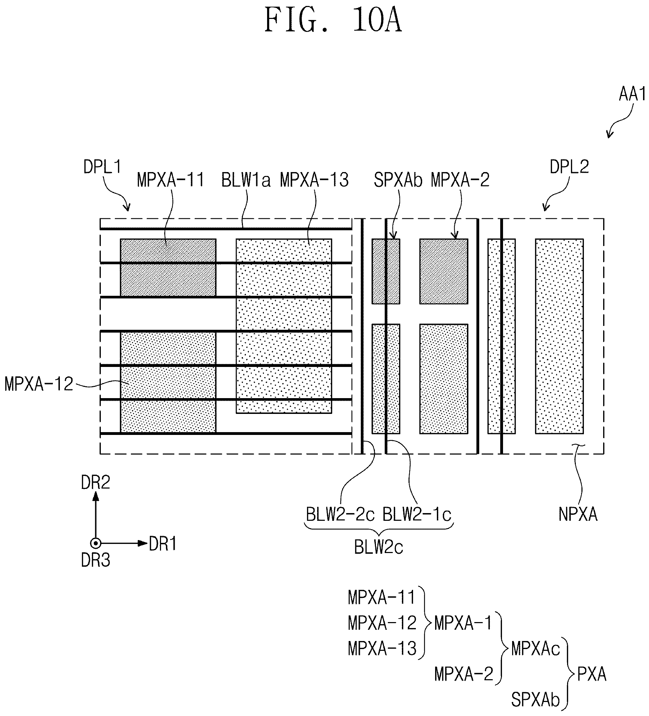

FIGS. 10A to 10C are views for describing a first display surface and the second display surface, according to an embodiment.

As shown, FIGS. 10A to 10C are enlarged plan views of a portion corresponding to the first area AA1 of the display surface DPL illustrated in FIG. 5.

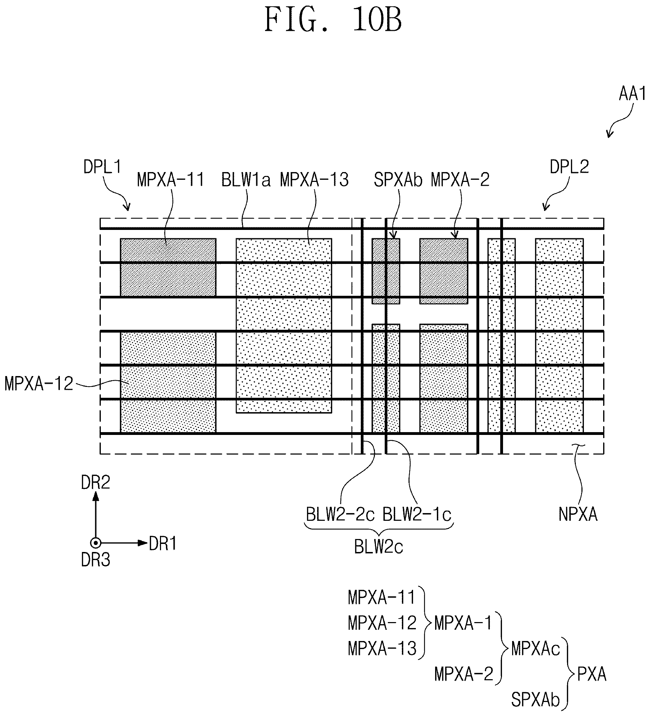

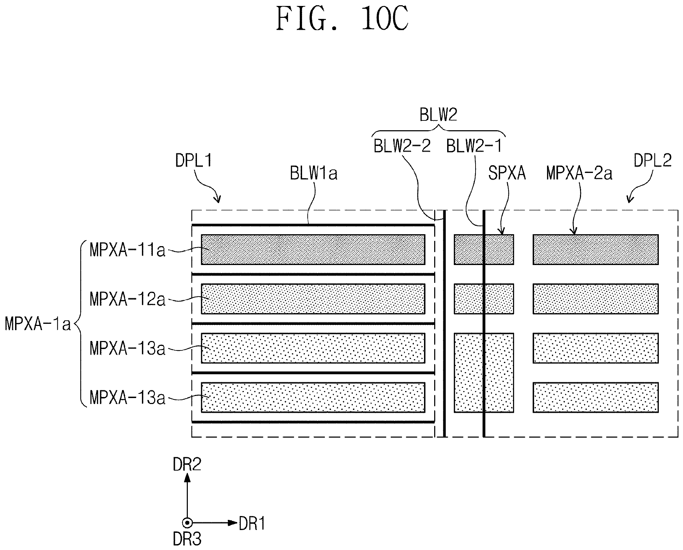

For convenience of description, FIGS. 10B and 10C will be described mainly in terms of differences from FIG. 10A.

In an embodiment and referring to FIGS. 10A and 10B, light emitting areas PXA may be defined on the first display surface DPL1 and the second display surface DPL2. The light emitting area PXA may include a main light emitting area MPXAc and the sub-light emitting area SPXAb. The main light emitting area MPXA-1c may include a first main light emitting area MPXA-1 and a second main light emitting area MPXA-2.

The first main light emitting area MPXA-1 may be defined on the first display surface DPL1. The second main light emitting area MPXA-2 and the sub-light emitting area SPXAb may be defined on the second display surface DPL2. The arrangement shape of the first main light emitting area MPXA-1 and the arrangement shape of the second main light emitting area MPXA-2 may be different from each other.

The second main light emitting area MPXA-2 and the sub-light emitting area SPXAb may be substantially the same as the main light emitting area MPXAb and the sub-light emitting area SPXAb illustrated in FIG. 8A. Further, the arrangement shape of the second main light emitting area MPXA-2 and the arrangement shape of the sub-light emitting area SPXAb may be substantially the same as the arrangement shape of the main light emitting area MPXAb and the arrangement shape of the sub-light emitting area SPXAb in FIG. 8A.

Hereinafter, descriptions of the second main light emitting area MPXA-2 and the sub-light emitting area SPXAb defined on the second display surface DPL2 will be omitted, and the first main light emitting area MPXA-1 defined on the first display surface DPL1 will be described.

The first main light emitting area MPXA-1 may include a (1-1)^{th} light emitting area MPXA-11, a (1-2)^{th} light emitting area MPXA-12, and a (1-3)^{th} light emitting area MPXA-13, where the (1-1)^{th} light emitting area MPXA-11 may emit a red light, the (1-2)^{th} light emitting area MPXA-12 may emit a green light, and the (1-3)^{th} light emitting area MPXA-13 may emit a blue light.

On a plane, the (1-1)^{th} light emitting area MPXA-11 and the (1-2)^{th} light emitting area MPXA-12 may be arranged in the second direction DR2. On a plane, the (1-1)^{th} light emitting area MPXA-11 and the (1-3)^{th} light emitting area MPXA-13 may be arranged in the first direction DR1. On a plane, the (1-2)^{th} light emitting area MPXA-12 and the (1-3)^{th} light emitting area MPXA-13 may be arranged in the first direction DR1.

As shown, the (1-1)^{th} light emitting area MPXA-11, the (1-2)^{th} light emitting area MPXA-12, and the (1-3)^{th} light emitting area MPXA-13 may have a rectangular shape. Moreover, an area of the (1-2)^{th} light emitting area MPXA-12 may be greater than an area of the (1-1)^{th} light emitting area MPXA-11, and the area of the (1-2)^{th} light emitting area MPXA-12 may be smaller than an area of the (1-3)^{th} light emitting area MPXA-13.

Referring to FIG. 10A, the first partition walls BLW1a may be arranged on the first display surface DPL1. The first partition walls BLW1a may not be arranged on the second display surface DPL2. The first partition walls BLW1a may extend on the first display surface DPL1 in the first direction DR1 and may be arranged in the second direction DR2. A distance between the first partition walls BLW1a disposed adjacent to each other in the second direction DR2 may be uniform.

At least one first partition wall BLW1a among the first partition walls BLW1a may be disposed on the first main light emitting area MPXA-1. At least one first partition wall BLW1a among the first partition walls BL W1a may overlap the first main light emitting area MPXA-1.

The light emitted from the first main light emitting area MPXA-1 may not travel in the second direction DR2 and in a direction opposite to the second direction DR2 due to the first partition walls BL W1a. Accordingly, the image provided from the first area DA1 of FIG. 1 may not be focused on the front window FWI. Thus, when the vehicle VH operates, the image provided from the display device DD may not disturb the driver.

The second partition walls BLW2c may be arranged on the second display surface DPL2. The second partition walls BLW2c may not be arranged on the first display surface DPL1. The light emitted from the sub-light emitting area SPXAb may not travel in a direction opposite to the first direction DR1 due to the second partition walls BLW2c. Accordingly, it is possible to prevent the image provided from the second area DA2 of FIG. 1 from being visually recognized by the driver. Hereinafter, since the second partition walls BLW2c of FIG. 10A are substantially the same as the second partition walls BLW2c of FIG. 8A, a description thereof will be omitted.

In an embodiment and referring to FIG. 10B, the first partition walls BLW1a may be arranged on the first display surface DPL1 and the second display surface DPL2. The first partition walls BLW1a may extend on the first and second display surfaces DPL1 and DPL2 in the first direction DR1. On a plane, the first partition walls BLW1a arranged on the second display surface DPL2 may intersect the second partition walls BLW2c.

At least one first partition wall BLW1a among the first partition walls BLW1a arranged on the second display surface DPL2 may overlap the second main light emitting area MPXA-2 and the sub-light emitting area SPXAb. The lights emitted from the second main light emitting area MPXA-2 and the sub-light emitting area SPXAb may not travel in the second direction DR2 and in a direction opposite to the second direction DR2 due to the first partition walls BLW1a.

In an embodiment and referring to FIG. 10C, a first main light emitting area MPXA-1a may be defined on the first display surface DPL1. The first main light emitting area MPXA-1a may include a (1-1)^{th} light emitting area MPXA-1 1a, a (1-2)^{th} light emitting area MPXA-12a, and a plurality of (1-3)^{th} light emitting areas MPXA-13a.

On a plane, the (1-1)^{th} light emitting area MPXA-1 1a, the (1-2)^{th} light emitting area MPXA-12a, and the plurality of (1-3)^{th} light emitting areas MPXA-13a may be arranged in the second direction DR2.

On a plane, the (1-1)^{th} light emitting area MPXA-1 1a, the (1-2)^{th} light emitting area MPXA-12a, and the plurality of (1-3)^{th} light emitting areas MPXA-13a may have a rectangular shape. On a plane, the (1-1)^{th} light emitting area MPXA-1 1a, the (1-2)^{th} light emitting area MPXA-12a, and the plurality of (1-3)^{th} light emitting areas MPXA-13a may have the same area.

The first partition walls BLW1a may be arranged between the (1-1)^{th} light emitting area MPXA-11a, the (1-2)^{th} light emitting area MPXA-12a, and the plurality of (1-3)^{th} light emitting areas MPXA-13a that are disposed adjacent to each other in the second direction DR2. The first partition walls BLW1a may extend between the (1-1)^{th} light emitting area MPXA-11a, the (1-2)^{th} light emitting area MPXA-12a, and the plurality of (1-3)^{th} light emitting areas MPXA-13a in the first direction DR1.

Lights emitted from the (1-1)^{th} light emitting area MPXA-1 1a, the (1-2)^{th} light emitting area MPXA-12a, and the plurality of (1-3)^{th} light emitting areas MPXA-13a may not travel in the second direction DR2 and in a direction opposite to the second direction DR2.

The second main light emitting area MPXA-2a and the sub-light emitting area SPXA may be substantially the same as the main light emitting area MPXA and the sub-light emitting area SPXA illustrated in FIG. 6A. Further, the arrangement shape of the second main light emitting area MPXA-2a and the arrangement shape of the sub-light emitting area SPXA may be substantially the same as the arrangement shape of the main light emitting area MPXA and the arrangement shape of the sub-light emitting area SPXA in FIG. 6A.

Additionally, the second partition walls BLW2 may be arranged on the second display surface DPL2 and may not be arranged on the first display surface DPL1. The light emitted from the sub-light emitting area SPXA may not travel in a direction opposite to the first direction DR1 due to the second partition walls BLW2. Accordingly, it is possible to prevent the image provided from the second area DA2 of FIG. 1 from being visually recognized by the driver. Hereinafter, since the second partition walls BLW2 of FIG. 10C are substantially the same as the second partition walls BLW2 of FIG. 6A, a description thereof will be omitted.

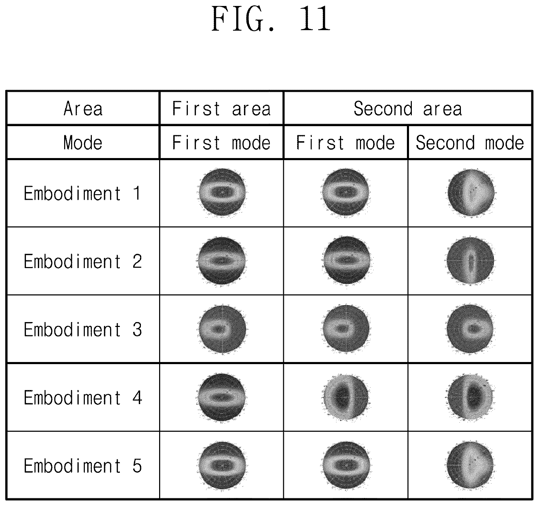

FIG. 11 is a view for describing a movement direction of a light emitted from the display panel, according to an embodiment.

Referring to FIG. 11, visual modes of embodiments described in FIG. 6A, FIG. 7A, FIG. 8A, FIG. 10A and FIG. 10B are shown.

In an embodiment and referring to FIGS. 6A to 8B and 11, the arrangement shape of the main light emitting areas MPXA, MPXAa, and MPXAb and the arrangement shape of the sub-light emitting areas SPXA, SPXAa, and SPXAb defined on the first display surface DPL1 may be the same as the arrangement shape of the main light emitting areas MPXA, MPXAa, and MPXAb and the arrangement shape of the sub-light emitting areas SPXA, SPXAa, and SPXAb defined on the second display surface DPL2.

In an embodiment, when the first display surface DPL1 and the second display surface DPL2 are driven in the first mode, a light emitted from the first display surface DPL1 and a light emitted from the second display surface DPL2 may not travel toward an upper side and a lower side. Accordingly, the image provided on the display device DD (see FIG. 1) may not be focused on the front window FWI (see FIG. 1) and a color of the light emitted from the first display surface DPL1 and a color of the light emitted from the second display surface DPL2 may be substantially the same.

In an embodiment, when the second display surface DPL2 is driven in the second mode, the light emitted from the second display surface DPL2 may not travel to a left side. Accordingly, it is possible to prevent the image provided on the second display surface DPL2 from being visually recognized by the driver.

In an embodiment and referring to FIGS. 10A to 11, in an embodiment, the arrangement shape of the first main light emitting area MPXA-1 defined on the first display surface DPL1 may be different from the arrangement shape of the second main light emitting area MPXA-2 defined on the second display surface DPL2. Further, the sub-light emitting areas SPXA and SPXAb may not be defined on the first display surface DPL1.

In an embodiment, when the first display surface DPL1 is driven in the first mode, the light emitted from the first display surface DPL1 may not travel toward an upper side and a lower side. Since the first partition walls BLW1a are not arranged on the second display surface DPL2, the light may travel to an upper side and a lower side. Since the first partition walls BLW1a are arranged on the second display surface DPL2, the light may not travel to an upper side and a lower side. In an embodiment, the color of the light emitted from the first display surface DPL1 and the brightness of the light emitted from the second display surface DPL2 may be different.

In an embodiment, when the second display surface DPL2 is driven in the second mode, the light emitted from the second display surface DPL2 may not travel to a left side.

In an embodiment, the first partition walls BLW1a may be arranged on the first display surface DPL1, and the second partition walls BLW2b may not be arranged on the first display surface DPL1. Accordingly, areas of the first main light emitting areas MPXA-1 and MPXA-1a that may emit lights may relatively increase as compared to an embodiment. Thus, since a relatively small current is applied, lifespans of the pixels PX (see FIG. 5) may be improved.

According to an embodiment of the invention, a plurality of first partition walls may be arranged on a first area to shield a light emitted toward a front window and a plurality of second partition walls may be arranged on the second area to prevent an image from being visually recognized by a user sitting in a driver seat.

Although embodiments of the invention have been described, it is understood that the invention should not be limited to these embodiments and that various changes and modifications can be made by one of ordinary skill in the art. Therefore, the scope of the invention should not be limited to any single embodiment described herein or otherwise. Moreover, embodiments or parts of the embodiments may be combined in whole or in part.

## Claims

1. A display device (DD) comprising:
a display panel (DP) including a first display surface (DPL1) and a second display surface (DPL2), wherein the first display surface (DPL1) and the second display surface (DPL2) are defined continuously in a first direction (DR1) on a plane; and
a light control layer (LCL) disposed on the display panel (DP),
wherein the light control layer (LCL) includes:
a first partition wall (BLW1) extending on the first display surface (DPL1) in the first direction (DR1); and
a second partition wall (BLW2) extending on the second display surface (DPL2) in a second direction (DR2) intersecting the first direction (DR1).

2. The display device (DD) of claim 1, wherein the display panel (DP) includes:
a plurality of main light emitting areas (MPXA) defined on the first display surface (DPL1) and the second display surface (DPL2); and
a plurality of sub-light emitting areas (SPXA) defined on the second display surface (DPL2), wherein the plurality of sub-light emitting areas (SPXA) are arranged to be adjacent to the main light emitting areas (MPXA), and
wherein the second partition wall (BLW2) overlaps the plurality of sub-light emitting areas (SPXA) on the plane.

3. The display device (DD) of claim 2, wherein an arrangement shape of the main light emitting areas (MPXA) defined on the first display surface (DPL1) and an arrangement shape of the main light emitting areas (MPXA) defined on the second display surface (DPL2) are different from each other.

4. The display device (DD) of at least one of claims 1 to 3, wherein the first partition wall (BLW1) is disposed on the second display surface (DPL2), and
wherein the first partition wall (BLW1) intersects the second partition wall (BLW2) on the second display surface (DPL2).

5. The display device (DD) of claim 2, wherein the sub-light emitting areas (SPXA) are defined on the first display surface (DPL1) to be disposed adjacent to the main light emitting areas (MPXA), and
wherein the second partition wall (BLW2) is disposed on the first display surface (DPL1) and overlaps the sub-light emitting areas (SPXA).

6. The display device (DD) of claim 5, wherein an arrangement shape of the main light emitting areas (MPXA) and an arrangement shape of the sub-light emitting areas (SPXA) defined on the first display surface (DPL1) are the same as an arrangement shape of the main light emitting areas (MPXA) and an arrangement shape of the sub-light emitting areas (SPXA) defined on the second display surface (DPL2).

7. The display device (DD) of claim 6, wherein the main light emitting areas (MPXA) and the sub-light emitting areas (SPXA) are arranged in the first direction (DR1).

8. The display device (DD) of claim 6, wherein the main light emitting areas (MPXA) and the sub-light emitting areas (SPXA) are arranged in the second direction (DR2).

9. The display device (DD) of claim 6, wherein the main light emitting areas (MPXA) include:
a first light emitting area (MPXA1);
a second light emitting area (MPXA2) defined to be spaced apart from the first light emitting area (MPXA1) in the second direction (DR2); and
a third light emitting area (MPXA3) defined to be spaced apart from the first light emitting area (MPXA1) and the second light emitting area (MPXA2) in the first direction (DR1), and
wherein the sub-light emitting areas (SPXA) include:
a first sub-light emitting area (SPXA1) defined on one side of the first light emitting area (MPXA1);
a second sub-light emitting area (SPXA2) defined on one side of the second light emitting area (MPXA2); and
a third sub-light emitting area (SPXA3) defined between another side of the first light emitting area (MPXA1) and one side of the third light emitting area (MPXA3) facing the other side of the first light emitting area (MPXA1) and disposed between another side of the second light emitting area (MPXA2) and the one side of the third light emitting area (MPXA3).

10. The display device (DD) of at least one of claims 1 to 9, wherein the display panel (DP) includes:
a circuit element layer (DP-CL);
a display element layer (DP-ED) disposed on the circuit element layer (DP-CL) and including a plurality of light emitting elements; and
a thin film encapsulation layer (TFE) disposed on the display element layer (DP-ED),
wherein the light control layer (LCL) is disposed on the thin film encapsulation layer (TFE).

11. The display device (DD) of claim 10, wherein the display panel (DP) further includes:
an input sensing layer disposed between the thin film encapsulation layer (TFE) and the light control layer (LCL).

12. The display device (DD) of claim 11, wherein the display panel (DP) further includes:
a reflection preventing layer (ARL) disposed between the input sensing layer and the light control layer (LCL).

13. The display device (DD) of at least one of claims 1 to 12, wherein the light control layer (LCL) includes a plurality of first partition walls (BLW1) arranged in the second direction (DR2), and
wherein a first length (L1) which is defined as a distance between adjacent first partition walls (BLW1) among the plurality of first partition walls (BLW1) in the second direction (DR2) is smaller than a second length (L2) which is defined as a thickness of a first partition wall (BLW1) among the plurality of first partition walls (BLW1).

14. The display device (DD) of at least one of claims 1 to 13, wherein the light control layer (LCL) includes a plurality of second partition walls (BLW2) arranged in the first direction (DR1), and
wherein a thickness of a second partition wall (BLW2) among the plurality of second partition walls (BLW2) is greater than a distance between adjacent second partition walls (BLW2) among the plurality of second partition walls (BLW2) in the first direction (DR1).

15. The display device (DD) of at least one of claims 1 to 14, wherein the first partition wall (BLW1) includes a plurality of first sub-partition walls (SBL1) that are sequentially laminated in a third direction (DR3) which intersects a plane defined by the first direction (DR1) and the second direction (DR2), and
wherein the second partition wall (BLW2) includes a plurality of second sub-partition walls (SBL2) that are sequentially laminated in the third direction (DR3) on the plane.

16. A display device (DD) comprising:
a display panel (DP) including a circuit element layer (DP-CL) and a display element layer (DP-ED) disposed on the circuit element layer (DP-CL); and
a light control layer (LCL) disposed on the display panel (DP) and including a plurality of partition walls (BLW),
wherein a first length (L1) which is defined as a distance between partition walls (BLW) among a plurality of partition walls (BLW) is smaller than a second length (L2) which is defined as a height of a partition wall (BLW) among the plurality of partition walls (BLW).

17. The display device (DD) of claim 16, wherein the display panel (DP) includes a first display surface (DPL1) and a second display surface (DPL2) continuously defined in a first direction (DR1), and
wherein an arrangement shape of the plurality of partition walls (BLW) arranged on the first display surface (DPL1) and an arrangement shape of the plurality of partition walls (BLW) arranged on the second display surface (DPL2) are the same.

18. The display device (DD) of claims 16 or 17, wherein the plurality of partition walls (BLW) include:
a plurality of first partition walls (BLW1) arranged on the first display surface (DPL1) and the second display surface (DPL2) and extending in the first direction (DR1) on a plane; and
a plurality second partition walls (BLW2) arranged on the first display surface (DPL1) and the second display surface (DPL2) and extending in a second direction (DR2) intersecting the first direction (DR1).

19. The display device (DD) of claim 16, wherein the display panel (DP) includes a first display surface (DPL1) and a second display surface (DPL2) continuously defined in a first direction (DR1) on a plane, and wherein an arrangement shape of the plurality of partition walls (BLW) arranged on the first display surface (DPL1) and an arrangement shape of the plurality of partition walls (BLW) arranged on the second display surface (DPL2) are different from each other.

20. The display device (DD) of claim 19, wherein the plurality of partition walls (BLW) include:
a plurality of first partition walls (BLW1) arranged on the first display surface (DPL1) and extending in the first direction (DR1) on a plane; and
a plurality of second partition walls (BLW2) arranged on the second display surface (DPL2) and extending in a second direction (DR2) interesting the first direction (DR1).
